# EUROPEAN PATENT SPECIFICATION

(11) **EP 1 713 596 B1**
(45) Date of publication and mention of the grant of the patent: **27.03.2013**
(21) Application number: 04821574.3
(22) Date of filing: 15.11.2004
(51) Int. Cl.: H01L 39/24

(54) **OXIDE FILMS WITH NANODOT FLUX PINNING CENTERS**
OXIDFILME MIT NANODOT-FLUX-PINNING-ZENTREN
FILMS D'OXYDE A CENTRES D'ANCRAGE DE FLUX COMPRENANT DES NANOPOINTS

(30) Priority: 16.01.2004 US 758710
(43) Date of publication of application: 25.10.2006
(73) Proprietor: AMERICAN SUPERCONDUCTOR CORPORATION, Devens, MA 01434 (US)
(72) Inventor: RUPICH, Martin, W., Framingham, MA 01701 (US); KODENKANDATH, Thomas, N. Grafton, MA 01536 (US); ZHANG, Wei, Shrewsbury, MA 01545 (US); LI, Xiaoping, Westborough, MA 01581 (US)
(74) Representative: Pugh, Robert Ian
(86) International application number: PCT/US2004/038025
(87) International publication number: WO 2005/081710

(56) References cited:
- US-A- 5 627 140
- US-A- 5 897 945
- US-B1- 6 602 588
- US-B1- 6 624 122
- US-B1- 6 673 387
- US-B1- 6 676 811
- US-B2- 6 586 042
- LI Y ET AL: "Positron annihilation study on the stress-field pinning mechanism in (Eu,Y)-123 superconductors" PHYSICA C, vol. 314, no. 1-2, 1 March 1999 (1999-03-01), pages 55-68, XP004163406 ISSN: 0921-4534
- LU P ET AL: "HIGH DENSITY, ULTRAFINE PRECIPITATES IN YBA2CU3O7-X THIN FILMS PREPARED BY PLASMA-ENHANCED METALORGANIC CHEMICAL VAPOR DEPOSITION" APPLIED PHYSICS LETTERS, vol. 60, no. 10, 9 March 1992 (1992-03-09) , pages 1265-1267, XP000289998 ISSN: 0003-6951
- CAPLIN A D ET AL: "The current-voltage relationship in crystals and conductors" PHYSICA C, vol. 401, no. 1-4, 15 January 2004 (2004-01-15), pages 1-6, XP004480962 ISSN: 0921-4534

## Description

### Field of the Invention

The present invention relates generally to increasing flux pinning and enhancing critical current density carrying capacity of superconducting materials. The present invention also relates to superconducting structures and to a method of improving superconducting flux pinning properties of rare earth-alkaline earth-transition metal oxide films.

### Background of the Invention

Since the discovery of high-temperature superconducting (HTS) materials (superconducting above the liquid nitrogen temperature of 77 K) there have been efforts to research and develop various engineering applications using such HTS materials. In thin film superconductor devices and wires, the most progress has been made with fabrication of devices utilizing an oxide superconductor including yttrium, barium, copper and oxygen in the well-known basic composition of YBa₂Cu₃O₇₋ₓ (hereinafter referred to as Y123). Much progress has also been made with rare earth elements "RE" substituted for Y. Biaxially textured superconducting metal oxides, such as Y123, have achieved high critical current densities in a coated conductor architecture. These wires are often referred to as second generation HTS wires. Thus, Y123 is the preferred material for many applications, including cables, motors, generators, synchronous condensers, transformers, current limiters, and magnet systems for military, high energy physics, materials processing, transportation and medical uses.

Even though Y123 is the material of choice for HTS applications, improvements in critical current density, in particular, critical current density in high magnetic fields and temperatures (J_{c}(H,T)), would reduce application costs, and reduce the size and weight of the system. Hence, it has been important to continue to improve the performance of Y123 films. This improvement can come by improving the "pinning" of the superconducting vortices, which is the underlying mechanism for high critical current density J_{c} in HTS materials.

To achieve pinning in superconductors, local potential energy differences should be matched in size as closely as possible to the size of the normal core of the superconducting flux line or vortex. The cross-sectional core has a size on the order of the coherence length, which is several nanometers in high temperature superconducting cuprates and grows with temperature. Thus, nanometer-sized defects are attractive in pinning the flux lines. Atomistic variations from randomness in atomic site occupations can also be effective even though there is some averaging of the resulting strain fields on the nanometer scale.

There have been efforts to improve flux pinning of bulk superconducting materials. For example, Jin et al., Physica C, vol. 173, pp. 75-79 (1991), describe the superconducting properties of YBa₂Cu₃O₇₋ₓ compounds with partial rare earth substitutions. Substitutions with europium (Eu), gadolinium (Gd), and samarium (Sm) were found to show a slight improvement in intragrain J_{c} (flux pinning). Skakle et al., Material Science and Engineering, vol. R23, pp. 1-40 (1998), report on the doping of YBa₂Cu₃O₇₋ₓ with a wide range of dopants at the Y, Ba and Cu sites.

However, the introduction of defects to increase critical current density to a useful level has met with only limited success. For example, in Gammel et al., Phys. Rev. Lett., 59, 2592 (1987), an increased density of twin boundaries provides only moderate improvement in flux pinning. Some increase in J_{c} in YBa₂Cu₃O₇₋ₓ was achieved by the introduction of point defects by neutron irradiation in, for example, United States Patent No. 6,493,411 to Chu et al. Critical currents in polycrystalline high-temperature superconductors are still further reduced by weak links at the grain boundaries, which are made worse by high porosity, misalignment of the crystalline axis of adjacent grains, and by formation and accumulation of non-superconductor phases (compounds) at boundaries between superconducting grains.

Despite the variety of work with bulk materials, there have been only a few attempts at forming thin films of Y123 compositions with enhanced flux pinning. For example, Scotti di Uccio et al., Physica C, vol. 321, pp 162-176 (1999), disclose the formation of yttrium-based impurities such as Y₂O₃ and Y₂BaCuO₅ (Y211) in Y123 thin films. United States Patent No. 6,602,588 to Kwon et al. describes a multilayer thin film superconducting composition having alternating layers of two rare earth materials, (RE)123. United States Patent No. 6,624,122 to Holesinger et al. also describes RE-123 thin films containing a mixture of rare earth elements.

US 6,673,387 relates to the formation of dense, highly textured metal oxide films from precursor films containing metals or metal oxides and metal halides.

Li et al., Physica C, vol 314, pp 55-68 (1999), describes the results from carrying out measurements of positron annihilation and AX susceptibility performed on (EuY) Ba₂Cu₃O₇-y compounds.

Lu et al., Appl. Phys. Lett, vol 60, pp 1265-1267 (1992), relates to the study of thin films of yttrium-rich YBa₂Cu₃O₇-x with c-axis orientation prepared by plasma-enhanced metalorganic chemical vapor deposition.

### Summary of the Invention

In one aspect of the present invention, new and improved methods for increasing the critical current density of superconducting materials and of introducing nanometersized defects (nanodots) therein are provided. The present invention, as defined by claim 1, provides simple and versatile methods for introducing a range of pinning center defects of different compositions and morphologies into an oxide superconductor article. In other aspects of the invention, controlling and optimizing the size, shape, and distribution of pinning centers within the superconductor film are described.

Improved metal oxide thin films containing pinning centers and methods of manufacturing metal oxide and oxide superconductor thin films are also disclosed.

In one aspect of the invention, a precursor solution including (1) precursor components for the formation of a rare-earth/alkaline-earth-metal/transition-metal oxide (hereinafter "RE-123"), and (2) additive components and/or dopant components for the formation of flux pinning sites is used in a solution-based method to obtain a superconducting film having pinning centers.

In one or more embodiments of the present invention, a dopant component is included in the precursor solution to Provide a dopant metal that partially substitutes for a metal of the precursor component of the precursor solution. Generally, a dopant component can be any metal compound that is soluble in the solvent(s) contained in the precursor solution and that, when processed to form an oxide superconductor, provided a dopant metal that substitutes for an element of the oxide superconductor.

In one or more embodiments of the present invention, an additive component is included in the precursor solution. The additive component includes soluble compounds of rare earths, alkaline earths or transition metals, cerium, zirconium, silver, aluminum, or magnesium that can form second phase nanoparticles that acts as pinning sites in an oxide superconductor film. Generally, the additive compound can be any metal compound that is soluble in the solvent(s) contained in the precursor solution and that forms metal oxide or metal in the oxide superconductor film.

In one or more embodiments, an additive component includes rare earth, alkaline metal or transition metal compounds in excess of or in addition to those of the precursor component.

In one or more embodiments, the additive component is added to the precursor solution as a powder to form a nanoparticle dispersion.

The present invention provides RE-123 superconducting compositions of rare earth or yttria/alkaline-earth-metal/transition-metal oxides (hereinafter "RE-123") in a thin film architecture with improved flux pinning properties. Significant improvement in field trapping behavior is observed upon introduction of nanometer-sized defects (nanodots, second phase nanoparticles, or other chemical or structural modifications to the oxide superconductor grains) into the superconducting phase material. As used herein, "nanodots" or "nanoparticles" refers to particles on the order of 1-100 nanometers in all dimensions. Enhanced pinning can also result from point pinning centers such as those created by atomic defects or elemental substitutions to the RE-123 structure. All of the above types of pinning centers have the additional benefit that they have a more isotropic behavior as compared to defects structures like twin boundaries or dislocations.

### Brief Description of the Drawing

The present invention is described with reference to the following drawings, which are presented for the purpose of illustration only and are not intended to be limiting of the invention.
Fig. 1 illustrates the Ic dependence of Y123 (YBCO) film on an oxide-buffered metal substrate as a function of magnetic field and temperature.
Fig. 2 illustrates Ic as a function of field orientation of a Y123 film on an oxide-buffered metal substrate.
Fig. 3 shows an X-ray diffraction pattern of a Y123 film on a textured Ni(5at% W)/Y₂O₃/YSZ/ CeO₂ substrate.
Fig. 4 is a ratio of the critical current of Y123 films at 27K in a 1T field (perpendicular to the tape) to the critical current at 77K in self field.
Fig. 5 illustrates the critical current per width (A/cm-width) at 75.5K of a stoichiometric Y123 film and a excess-Y-doped Y123 film as a function of the angle of a 1 Tesla magnetic field relative to the planar face of the film.
Fig. 6 is a transmission electron micrograph (TEM) of a excess-Y-doped Y123 film showing presence of numerous nanometer-scale (nanodot) particles with the general composition of Y₂O₃ or Y₂Cu₂O₅ throughout the Y123 matrix.
Fig. 7 is an X-ray diffraction pattern of a BaCeO₃-doped Y123 film on a Ni(5at% W)/Y₂O₃/YSZ/CeO₂ substrate.
Fig. 8 is a cross-sectional view of a superconducting article according to one or more embodiments of the invention.

### Detailed Description of the Invention

A number of factors are relevant to improving pinning in the RE-123 coated conductor articles including that (1) pinning effects are known to be temperature and field dependent and thus should be optimized for the working temperature and magnetic field, (2) performance should be examined at all angles and not just in the fields of H parallel to the plane face of the tape or the *a-b* plane of the Y123 (H//ab) or perpendicular to the plane face of the tape or *a-b* plane of the Y123 (H//c), and (3) absolute, rather than just relative, total current I_{c} per tape width (i.e., A/cm-width) performance should be optimized under working temperatures and fields.

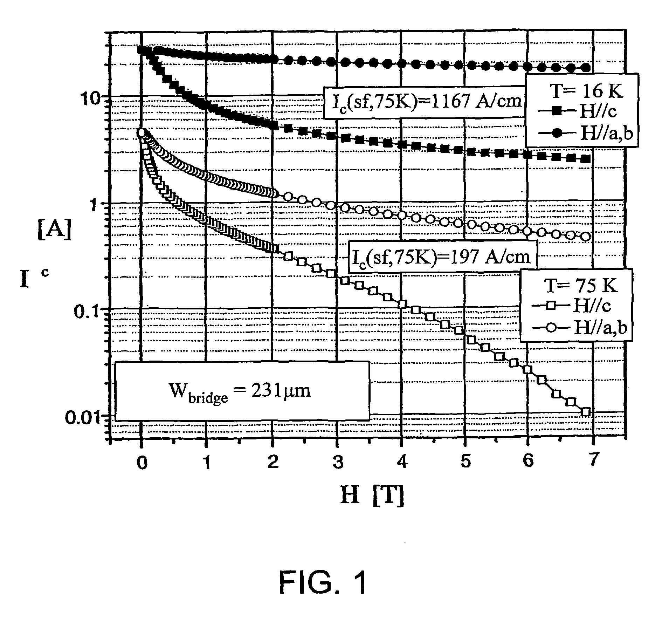

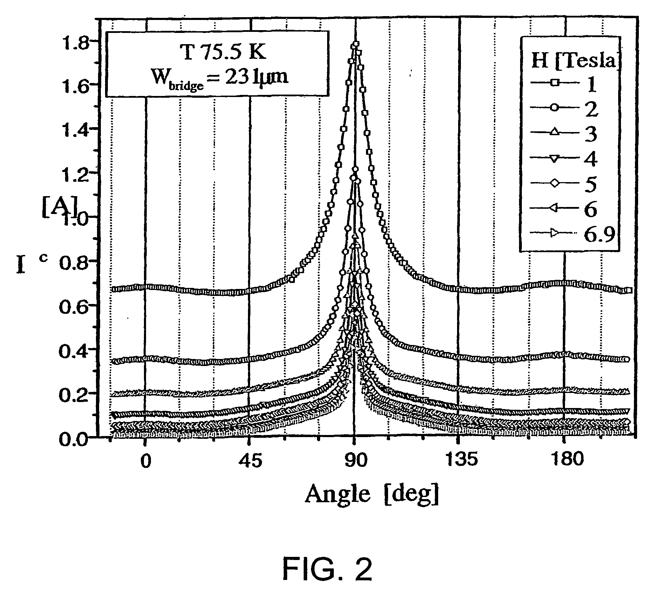

Fig. 1 shows the typical field dependence of a metal-organic deposited (MOD) Y123 film on an oxide-buffered metal substrate with magnetic field oriented parallel and perpendicular to the planar face of the film. At 75K, with the magnetic field oriented perpendicular to the planar face of the film, there is a significant decrease in Ic from the value in parallel orientation, limiting the usefulness of the Y123 wires in many coil applications. Although the performance improves as the temperature is lowered, many anticipated applications are planned for temperatures in the 55 to 65K region, in magnetic fields of 1 - 3 Tesla oriented perpendicular to the planar face of the film, which are conditions at which performance drops significantly. In addition to the parallel and perpendicular performance of the Y123 wires in magnetic field, it is important to examine the field performance at intermediate angles as shown in Figure 2. As seen in Fig. 2, Y123 films typically show a small peak in the c-axis (0 and 180° or perpendicular to the planar face of the Y123 film), which can be enhanced through the presence of extended planar or linear defects (e.g,, twin boundaries, grain boundaries, a-axis grains). However, for practical applications the Y123 wire performance is determined by the minimum performance with H in any orientation, and not solely by that at the perpendicular orientation.

Enhanced pinning can come from pinning centers, including dislocations created around particulate defects, atomistic defects created by elemental substitutions, and nanometer-sized particles or nanodots created by second phases in the RE-123 material, e.g., within the crystalline grains of the oxide superconductor. The nature of the defects can produce improved pinning of the magnetic flux in selective field orientation angles. Ideally, the pinning is isotropic, resulting in improved flux pinning at all angular orientations of the magnetic field.

The present invention uses a metal organic (solution based) deposition (MOD) process to obtain highly oriented oxide superconducting films having pinning centers. An MOD process represents an attractive system for introducing pinning centers because the precursor solution is versatile and can be varied over a wide range of compositions and concentrations. Although nanometer-sized particles and random atomic substitutions have been used before in superconductors to create pinning, it is not obvious how such centers can be introduced in an "ex-situ" process like the MOD process for RE-123. Because RE-123 grows in a front starting at the substrate interface, second phases and even different atoms can be segregated during the growth process.

Furthermore, during processing of precursor materials to the oxide superconductor film, non-superconducting phases that form in the film generally coarsen into relatively large second phase particles and are excluded from the oxide superconductor grains. These large second phase particles are expected to significantly reduce the critical current density of the oxide superconductor film and have no beneficial effect on pinning the flux lines in the oxide superconductor film in magnetic fields. Many of the currently available methods of processing oxide superconductor thin films are expected to be at risk for coarsening of non-superconductor phases.

The present invention provides the means to overcome these processing issues and to achieve appropriate pinning centers via a MOD process. According to one or more embodiments of the present invention, processing conditions are identified to permit formation of the nanodots in the 10 - 100 nm range and to include them in the oxide superconductor grains. In one or more embodiments, particle size for nanodots is less than about 50 nm, or even less than about 20 nm, to provide optimal pinning by best matching with the normal core of the flux-lines or vortices in the Type II superconductor. In one or more embodiments of the present invention, the overall growth of the oxide superconductor layer is sufficiently rapid to prevent the coarsening of the nanodots and to prevent their exclusion from the oxide superconductor grains.

In order to maintain the desired particle size and location within the oxide superconductor grains, the growth rate of the oxide superconductor from a precursor film is in the range of about 0.2-20 nm/s, or in the range of about 0.5-20 nm/s, or in the range of 1-20 nm/s, or greater than about 2 nm/s. By maintaining rapid growth under non-equilibrium conditions, the coarsening of the second phase particles and their expulsion from the oxide superconductor grains are reduced.

Pinning centers are introduced into superconducting thin films using a solution-based process, which allows control over the nature, composition, density and location of pinning centers in the RE-123 film. In one or more embodiments, a precursor solution is provided that contains precursor components for the formation of RE-123 and additive and/or dopant components for the formation of pinning centers.

Such precursor solutions can be used to form a film containing an intermediate of RE-123 (e.g. a metal oxyhalide intermediate) and the pinning metal or metal oxide. The intermediate film can then be further processed to form a RE-123 oxide superconductor film having nanodot pinning centers located within one or more oxide superconductor grains. Such flux-pinned oxide films exhibit improved critical current densities (e.g. at least about 1MA/cm² at 77K in self-field).

An oxyfluoride film is considered to be any film that is a precursor to a RE-123 oxide superconductor film that is comprised of (1) a mixture of BaF₂, a rare earth oxide or fluoride and/or transition metal, transition metal oxide or transition metal fluoride, (2) a mixture of a compound comprised of a RE-Ba-O-F phase, a rare earth oxide or fluoride and/or transition metal oxide or fluoride, or (3) as a mixture of a compound comprised of a Ba-O-F phase, rare earth oxides or fluorides and/or transition metal oxide or fluoride.

The precursor components include soluble compounds of one or more rare earth elements, one or more alkaline earth metals and one or more transition metals. As used herein, "soluble compounds" of rare earth elements, alkaline earth metals and transition metals refers to compounds of these metals that are capable of dissolving in the solvents contained in the precursor solution. Such compounds include, for example, salts (e.g., nitrates, acetates, alkoxides, halides, sulfates, and trifluoroacetates), oxides and hydroxides of these metals. At least one of the compounds is a fluorine-containing compound, such as the trifluoroacetate.

In general, the rare earth metal salt can be any rare earth metal salt that is soluble in the solvent(s) contained in the precursor solution and that, when being processed to form an intermediate (e.g., a metal oxyhalide intermediate), forms rare earth oxide(s) (e.g., Y₂O₃). The rare earth elements may be selected from the group of yttrium, cerium, neodymium, samarium, europium, gadolinium, terbium, dysprosium, holmium, erbium, thulium, ytterbium, and lutetium. Typically, the alkaline earth metal is barium, strontium or calcium. Generally, the alkaline earth metal salt can be any alkaline earth metal salt that is soluble in the solvent(s) contained in the precursor solution and that, when being processed to form an intermediate (e.g., a metal oxyhalide intermediate), forms an alkaline earth halide compound (e.g., BaF₂, BaCl₂, BaBr₂, BaI₂) prior to forming alkaline earth oxide(s) (e.g., BaO). Generally, the transition metal is copper. The transition metal salt should be soluble in the solvent(s) contained in the precursor solution. In one or more embodiments of the present invention, the rare earth and the alkaline earth elements can form a metal or mixed metal oxyfluoride in place of or in addition to a rare earth oxide and an alkaline earth fluoride.

According to one or more embodiments of the present invention, second phase nanodots are introduced into the RE-123 grains by addition of stoichiometric excess of the elements used in forming RE-123 or by addition of other elements that precipitate out or nucleate as nanometer-sized second phases. Additive components include soluble and insoluble metal compounds that can be further processed to form nanodots. "Soluble compounds" of metal compounds used in the formation of nanodots refer to compounds of these metals, e.g., rare earths, such as yttrium, neodymium, samarium, europium, gadolinium, terbium, dysprosium, holmium, erbium, thulium, ytterbium, and lutetium, alkaline earth metals, such as calcium, barium and strontium, transition metals, such as scandium, titanium, vanadium, chromium, manganese, iron, cobalt, nickel and zirconium, cerium, silver, aluminum, and magnesium that are capable of dissolving in the solvents contained in the precursor solution. Such compounds include, for example, salts (e.g., nitrates, acetates, alkoxides, halides, sulfates, and trifluoroacetates), oxides and hydroxides of these metals.

In one or more embodiments, additive components may include stoichiometric excesses of soluble compounds included in the precursor solution as precursor components. For example, soluble yttrium salts may be included in the precursor solution in excess of that required to form Y123. The excess yttrium is processed according to one or more embodiments of the present invention to form yttrium-rich secondary phase nanoparticles, such as Y₂BaCuO₅ (Y211), Y₂Cu₂O₅ and/or Y₂O₃, which serve as particulate pinning sites in the superconducting oxide film. Typical particle density is about 20 - 10,000 particles per cubic micron of the film, or about 100-10,000 particles per cubic micron of the film, or about 1,000 - 10,000 particles per cubic micron (µm³) of the film. In one or more embodiments, the particle density is greater than 1,000 particles per µm³.

In one or more embodiments, additive components having metals other than those of the oxide superconductor may be included in the precursor solution. By way of example, soluble and insoluble compounds of cerium, zirconium, silver, aluminum and magnesium may be included in the precursor solution. Additive components are further processed according to one or more embodiments of the present invention to form single or mixed metal oxide nanodots that serve as pinning sites in the oxide superconductor film. By way of example, excess barium and cerium compounds are used as additive components in a precursor solution, and are processed to form nanodot pinning sites such as BaCeO₃. Additive components typically make up about 1-20 % of the total metal of the precursor solution. Typical atomic excess can range from 10-40%. Films with significantly improved flux pinning properties have been prepared using ~20% excess of barium and cerium (in equal atomic amounts), in combination.

In one or more embodiments, the additive component is insoluble and is included in the precursor solution as dispersed nanodots. The nanodots should be dispersed in the precursor with minimal agglomeration. Methods of dispersing the nanodots include ultrasonication, the addition of dispersants, and other techniques known in the art. In one or more embodiments of the present invention, the nanodots may be reactive with other components of the precursor solution. For example, a ceria (CeO₂) nanodispersion is included in the precursor solution and reacts with a barium component to form BaCeO₃. The resultant nanoparticles or nanodots are homogeneously distributed throughout the precursor solution. In one or more embodiments of the present invention, the nanodots are inert, e.g., non-reactive, to the other components of the precursor solution and they are uniformly dispersed in the precursor solution. The nanodot dispersion maintains a stable suspension so that the particles are homogeneously distributed throughout the resultant oxyfluoride film. With further processing, the nanodots are incorporated as pinning centers in the oxide superconductor film with a density of 20 - 10,000 particles per cubic micron of film.

According to one or more embodiments of the present invention, atomistic defects or elemental substitutions in the RE-123 grains is achieved by mixing different rare earths in the Y123 atomic structure. Most elements of the rare earth series (from lanthanum to lutetium) are known to enter into this atomic structure without substantially changing the superconducting transition temperature; yet their different atomic sizes create local pinning points from the strain fields or varying orbital energies. Some of the rare earths also have local magnetic moments, which can create another kind of local perturbation contributing to the pinning.

In one or more embodiments of the present invention, pinning sites are introduced into a RE-123 oxide superconductor by partial replacement of one or more of the elements of 123 oxide superconductor by a suitable dopant. Any of the rare earth elements, alkaline earth metals or transition metals can be doped. The presence of a different cation into the oxide structure introduces stresses that serve as pinning sites. In one or more embodiments, yttrium in Y123 is partially substituted with an alternative rare earth element, such as neodymium, samarium, europium, gadolinium, terbium, dysprosium, holmium, erbium, thulium, ytterbium, or lutetium. The doped-123 material may be RE₁/RE₂-123, where RE₁ and RE₂ represent two different rare earth elements, and larger numbers of different RE's can be used. Any combination of two or more rare earth elements may be used. Substitutions of up to 50 atomic percent are useful in one or more embodiments of the present invention. In one or more embodiments of the invention, substitutions for about 20 atomic weight percent may be used. More than two rare earths in the RE-123 may be used, for example the composition Nd-Eu-Gd is commonly used in bulk material for improved flux pinning.

In one or more embodiments, a precursor solution is provided that contains dopant components for the formation of a doped-123. The dopant components include soluble compounds of a rare earth elements, alkaline earth metals and/or transition metals that substitute for a metal of RE-123. Such compounds include, for example, salts (e.g., nitrates, acetates, alkoxides, iodides, sulfates, and trifluoroacetates), oxides and hydroxides of these metals. The degree of substitution can be controlled by appropriate adjustment of the composition of the precursor solution.

Combinations of the above additive components and dopant components are contemplated. By way of example, a precursor solution may include a soluble dopant component for partial replacement of a metal of the 123 superconductor and an additive component for formation of a secondary phase nanoparticle or nanodot. The additives may be soluble or may be dispersed nanoparticles. Other combinations will be apparent to those of skill in the art.

The solvent or combination of solvents used in the precursor solution can include any solvent or combination of solvents capable of dissolving the metal salts (e.g., metal trifluoroacetate(s)). Such solvents include, for example, alcohols, including methanol, ethanol, isopropanol and butanol.

In certain embodiments, the precursor composition has a relatively small amount of free acid. In aqueous solutions, this can correspond to a precursor composition with a relatively neutral pH (e.g., neither strongly acidic nor strongly basic). The total free acid concentration of the precursor composition can be less than about 10⁻³ molar (or less than about 10⁻⁵ molar or about 10⁻⁷ molar). Examples of free acids that can be contained in a precursor composition include trifluoroacetic acid, carboxylate acids, acetic acid, nitric acid, sulfuric acid, acids of iodides, acids of bromides and acids of sulfates. When the precursor composition contains water, the precursor composition can have a pH of at least about 3 (or at least about 5 or about 7). In some embodiments, the precursor composition can have a relatively low water content (e.g., less than about 50 volume percent water, less than about 35 volume percent water, or less than about 25 volume percent water).

In embodiments in which the metal salt solution contains trifluoroacetate ion and an alkaline earth metal cation (e.g., barium), the total amount of trifluoroacetate ion can be selected so that the mole ratio of fluorine contained in the metal salt solution (e.g., in the form of trifluoroacetate) to the alkaline earth metal (e.g., barium ions) contained in the metal salt solution is at least about 2:1 (e.g., from about 2:1 to about 18.5:1, or from about 2:1 to about 10:1).

In alternate embodiments, a precursor solution is formed of an organic solution containing metal trifluoroacetates prepared from powders of BaCO₃, Y₂(CO₃)₃3H₂O and Cu(OH)₂CO₃ and any additive and/or dopant components combined and reacted using methods known to those skilled in the art. For example, the Y:Cu powders can be combined in a 2:1:3 ratio with between 20-30% (5.5-6.0 M) excess trifluoroacetic acid in methyl alcohol and then refluxed (e.g., for approximately four to ten hours) to produce a solution substantially 0.94 M based on copper content. Additive and/or dopant components are added in amounts suitable to obtain defect densities of about 20-10000 per cubic micron of film.

The methods of disposing the superconducting composition on the underlying layer (e.g., on a surface of a substrate, such as a substrate having an alloy layer with one or more buffer layers disposed thereon) include spin coating, dip coating, slot coating, web coating and other techniques known in the art. Film thickness can vary, but is typically in the range of
0.2 - 3.0 µm, and more typically about 1 - 2 µm. In some embodiments in which spin coating is used, the composition is disposed on the underlying layer and the spin rate is ramped from about zero revolutions per minute (RPM) to about 2,000 RPM in about 0.5 second. This spin rate is held for about five seconds, and the spin rate is then ramped to about 4;000 RPM in about 0.5 second. This spin rate is held for about 60 seconds, and the spin rate is then decreased to about zero RPM. As known to those skilled in the art, other spin coating conditions can also be used. The resulting material is reacted (e.g., decomposed) in a furnace in a gas environment containing oxygen and water to form barium fluoride and/or other appropriate materials (e.g., CuO and/or Y₂O₃). For long wires, a web coating technique such as slot die coating or spray coating is preferred.

The composition is then heated. Generally, this step is performed to remove excess solvent (e.g., water and methanol) from the composition and to decompose the metalorganic molecules to one or more oxyfluoride intermediates of the desired superconductor material. It also may decompose the additive and/or dopant components to form one or more metal, oxide or oxyfluoride intermediates.

Typically, the initial temperature in this step is about room temperature, and the final temperature is from about 190°C to about 210°C, preferably to a temperature to about 200°C. Preferably, this step is performed using a temperature ramp of at least about 5°C per minute, more preferably a temperature ramp of at least about 10°C per minute, and most preferably a temperature ramp of at least about 15°C per minute.

During this step, the partial pressure of water vapor in the nominal gas environment is preferably maintained at from about 0.67kPa to about 6.67kPa (about 5 Torr to about 50 Torr), more preferably at from about 0.67kPa to about 6.67kPa (about 5 Torr to about 30 Torr), and most preferably at from about 2.67kPa to about 3.99kPa (about 20 Torr to about 30 Torr).

The partial pressure of oxygen in the nominal gas environment is maintained at from about 0.01 kPa to about 101.33kPa (about 0.1 Torr to about 760 Torr) and preferably at about 97.33kPa to about 98.66kPa (about 730-740 Torr).

Heating is then continued to a temperature of from about 200°C to about 290°C using a temperature ramp of from about 0.05°C per minute to about 5°C per minute (e.g., from about 0.5°C per minute to about 1°C per minute). Preferably, the gas environment during this heating step is substantially the same as the nominal gas environment used when the sample is heated to from the initial temperature to from about 190°C to about 215°C.

Heating is further continued to a temperature of about 650°C, or more preferably to a temperature of about 400°C, to form the oxyfluoride intermediate. This step is preferably performed using a temperature ramp of at least about 2°C per minute, more preferably at least about 3°C per minute, and most preferably at least about 5°C per minute. Preferably, the gas environment during this heating step is substantially the same as the nominal gas environment used when the sample is heated to from the initial temperature to from about 190°C to about 215°C.

In alternate embodiments, barium fluoride is formed by heating the dried solution from an initial temperature (e.g., room temperature) to a temperature of from about 190°C to about 215°C (e.g., about 210°C) in a water vapor pressure of from about 0.67kPa to about 6.67kPa (about 5 Torr to about 50 Torr) water vapor (e.g., from about 0.67kPa to about 6.67kPa (about 5 Torr to about 30 Torr) water vapor, or from about 1.33kPa to about 3.33kPa (about 10 Torr to about 25 Torr water vapor)). The nominal partial pressure of oxygen can be, for example, from about 0.01 kPa to about 101.33kPa (about 0.1 Torr to about 760 Torr). In these embodiments, heating is then continued to a temperature of from about 220°C to about 290°C (e.g., about 220°C) in a water vapor pressure of from about 0.67kPa to about 6.67kPa (about 5 Torr to about 50 Torr water vapor) (e.g., from about 0.67kPa to about 6.67kPa (about 5 Torr to about 30 Torr) water vapor, or from about 1.33kPa to about 3.33kPa (about 10 Torr to about 25 Torr water vapor)). The nominal partial pressure of oxygen can be, for example, from about 0.01 kPa to about 101.33kPa (about 0.1 Torr to about 760 Torr). This is followed by heating to about 400°C at a rate of at least about 2°C per minute (e.g., at least about 3°C per minute, or at least about 5°C per minute) in a water vapor pressure of from about 0.67kPa to about 6.67kPa (about 5 Torr to about 50 Torr) water vapor (e.g., from about 0.67kPa to about 6.67kPa (about 5 Torr to about 30 Torr) water vapor, or from about 1.33kPa to about 3.33kPa (about 10 Torr to about 25 Torr water vapor)) to form barium fluoride. The nominal partial pressure of oxygen can be, for example, from about 0.01 kPa to about 101.33kPa (about 0.1 Torr to about 760 Torr).

In other embodiments, heating the dried solution to form barium fluoride includes one or more steps in which the temperature is held substantially constant (e.g., constant within about 10°C, within about 5°C, within about 2°C, within about 1°C) for a relatively long period of time (e.g., more than about one minute, more than about five minutes, more than about 30 minutes, more than about an hour, more than about two hours, more than about four hours) after a first temperature ramp to a temperature greater than about room temperature. In these embodiments, heating the metal salt solution can involve using more than one gas environment (e.g., a gas environment having a relatively high water vapor pressure and a gas environment having a relatively low water vapor pressure) while maintaining the temperature substantially constant (e.g., constant within about 10°C, within about 5°C, within about 2°C, within about 1°C) for a relatively long period of time (e.g., more than about one minute, more than about five minutes, more than about 30 minutes, more than about an hour, more than about two hours, more than about four hours). As an example, in a high water vapor pressure environment, the water vapor pressure can be from about 0.67kPa to about 5.33kPa (about 5 Torr to about 40 Torr) (e.g., from about 3.33kPa to about 5.06kPa (about 25 Torr to about 38 Torr, such as about 4.27kPa (about 32 Torr). A low water vapor pressure environment can have a water vapor pressure of less than about 0.13kPa (about 1 Torr) (e.g., less than about (0.01 kPa (about 0.1 Torr), less than about 1 Pa (about 10 mTorr), about 0. 6Pa (about five mTorr).

In certain embodiments, heating the dried solution to form barium fluoride can include putting the coated sample in a pre-heated furnace (e.g., at a temperature of at least about 100°C, at least about 150°C, at least about 200°C, at most about 300°C, at most about 250°C, about 200°C). The gas environment in the furnace can have, for example, a total gas pressure of about 101.33kPa (about 760 Torr), a predetermined partial pressure of water vapor (e.g. at least about 1.33kPa (about 10 Torr), at least about 1.99kPa (about 15 Torr), at most about 3.33kPa (about 25 Torr), at most about 2.67kPa (about 20 Torr), about 2.27kPa (about 17 Torr)) with the balance being molecular oxygen. After the coated sample reaches the furnace temperature, the furnace temperature can be increased (e.g., to at least about 225°C, to at least about 240°C, to at most about 275°C, to at most about 260°C, about 250°C) at a predetermined temperature ramp rate (e.g., at least about 0.5°C per minute, at least about 0.75°C per minute, at most about 2°C per minute, at most about 1.5°C per minute, about 1°C per minute). This step can be performed with the same nominal gas environment used in the first beating step. The temperature of the furnace can then be further increased (e.g., to at least about 350°C, to at least about 375°C, to at most about 450°C, to at most about 425°C, about 450°C) at a predetermined temperature ramp rate (e.g., at least about 5°C per minute, at least about 8°C per minute, at most about 20°C per minute, at most about 12°C per minute, about 10°C per minute). This step can be performed with the same nominal gas environment used in the first heating step.

In some embodiments, preparation of a superconductor material can involve slot coating the metal salt solution (e.g., onto a tape, such as a tape formed of a textured nickel tape having sequentially disposed thereon epitaxial buffer and/or cap layers, such as Gd₂O3, yttria stabilized zirconia (YSZ) and CeO₂). The coated metal salt solution can be deposited in an atmosphere containing H₂O (e.g., from about 0.67kPa (about 5 Torr) H₂O to about 1.99kPa (about 15 Torr) H₂O, from about 1.19kPa (about 9 Torr) H₂O to about 1.73kPa (about 13 Torr) H₂O, about 1.47kPa (about 11 Torr) H₂O). The balance of the atmosphere can be an inert gas (e.g., nitrogen). The total pressure during film deposition can be, for example, about 101.33kPa (about 760 Torr). The film can be decomposed, for example, by transporting the coated tape through a tube furnace (e.g., a tube furnace having a diameter of about 6.35cm (about 2.5 inches)) having a temperature gradient. The respective temperatures and gas atmospheres of the gradients in the furnace, as well as the transport rate of the sample through each gradient, can be selected so that the processing of the film is substantially the same as according to the above-noted methods.

The foregoing treatments of a metal salt solution can result in an oxyfluoride intermediate film in which the constituent metal oxides and metal fluorides are homogeneously distributed throughout the film, including those of the pinning defects. Preferably, the precursor has a relatively low defect density and is essentially free of cracks through the intermediate thickness.

While solution chemistry for barium fluoride formation has been disclosed, other methods can also be used. For example, solid-state, or semi solid state, precursor materials deposited in the form of a dispersion. These precursor compositions allow for example the substantial elimination of BaCO₃ formation in final y123 superconducting layers, while also allowing control of film nucleation and growth.

The superconductor intermediate film can then be heated to form the desired superconductor layer. Without wishing to be bound by theory, it is believed that at elevated temperatures barium fluoride can reversibly react with a reactant gas (e.g., a reactant gas containing water) to form a BaO superconductor intermediate according to the equation:

BaF₂ + H₂O ↔ BaO + 2HF.

It is further believed that at these elevated temperatures the BaO superconductor intermediate can react with Y₂O₃ and CuO to form y123 according to the equation:

2BaO + 1/2Y₂O₃ + 3CuO ↔ YBa₂Cu₃Oₓ.

Typically, this step is performed by heating from about room temperature to a temperature of from about 700°C to about 825°C, preferably to a temperature of about 740°C to 800°C and more preferably to a temperature of about 750°C to about 790°C, at a temperature ramp of about greater than 25°C per minute, preferably at a temperature rate of about greater than 100°C per minute and more preferably at a temperature rate about greater than 200°C per minute. This step can also start from the final temperature of about 400 - 650°C used to form the intermediate oxyfluoride film. During this step, a process gas is flowed over the film surface to supply the gaseous reactants to the film and to remove the gaseous reaction products from the film.

The film is then held at a temperature of about 700°C - 825°C, preferably to a temperature of about 740°C to 800°C and more preferably to a temperature of about 750°C to about 790°C, for a time of about at least 5 minutes to about 120 minutes, preferably for a time of at least about 15 minutes to about 60 minutes, and more preferably for a time of at least about 15 minutes to about 30 minutes. During this step, a process gas is flowed over the film surface to supply the gaseous reactants to the film and to remove the gaseous reaction products from the film. The nominal gas environment during this step has a total pressure of about 0.01 kPa to about 101.33kPa (about 0.1 Torr to about 760 Torr) and is comprised of about 0.01 kPa to about 6.67kPa (about 0.09 Torr to about 50 Torr) oxygen and about 0.001 kPa to about 19.99kPa (about 0.01 Torr to about 150 Torr) water vapor and about 0kPa to about 99.99kPa (0 Torr to about 750 Torr) of an inert gas (nitrogen or argon).

More preferably, the nominal gas environment has a total pressure of about 0.02kPa to about 0.67kPa (about 0.15 Torr to about 5 Torr) and is comprised of about 0.01 kPa to about 0.13kPa (about 0.1 Torr to about 1 Torr) oxygen and about 0.006kPa to about 0.53kPa (about 0.05 Torr to about 4 Torr) water vapor.

One knowledgeable in the art realizes that the pressures of the gaseous reactants and the processing temperatures can vary as with the identity of the rare earth metals and alkaline earth metals used in the RE123 film

The film is then cooled to room temperature at in a nominal gas environment with an oxygen pressure of about 0.006kPa (about 0.05 Torr) to about 19.99kPa (about 150 Torr), preferably about 0.01 kPa (about 0.1 Torr) to about 0.06kPa (about 0.5 Torr), and more preferably from about 0.01 kPa (about 0.1 Torr) to about 0.02kPa (about 0.2 Torr).

These above conditions, including rapid ramp rates to the target heating temperature and heating and controlled supply of the gaseous reactants (e.g., O_{z} and H₂O) and remocal of the gaseous reaction products (e.g., HF), result in the rapid formation of Y12₃ and second phases. These reaction times result in the rapid nucleation and growth of the oxide superconductor through the intermediate film thickness, which favors the inclusion of small second phase particles (nanodots) within the Y123 grains. The reaction conditions which favor the rapid Y123 formation, reduce the likelihood of grain coarsening of the nanodots.

In alternate embodiments, the coating is heated for about one hour to a temperature of less than about 860°C (e.g., less than about 810°C) in a moist reducing nitrogen-oxygen gas mixture (e.g., having a composition including from about 0.5% to about 5% oxygen). The coating can be further heated to a temperature of from about 860°C to about 950°C for from about five to about 25 minutes. The coating is subsequently heated to a temperature of from about 400 °C to about 500 °C for at least about eight hours at in dry oxygen. The coating can then be cooled to room temperature in static dry oxygen.

The resultant superconductor layer is well-ordered (e.g., biaxially textured in plane, or c-axis out of plane and biaxially textured in plane). In embodiments, the bulk of the superconductor material is biaxially textured. A superconductor layer can be at least about one micrometer thick (e.g., at least about two micrometers thick, at least about three micrometers thick, at least about four micrometers thick, at least about five micrometers thick).

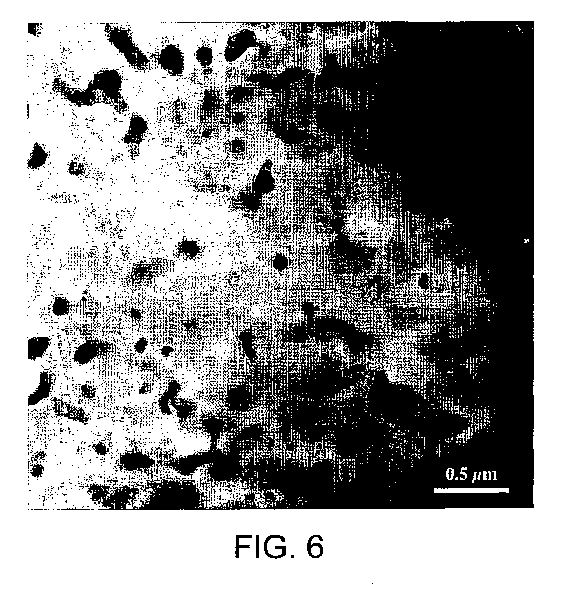

In the case of mixed rare earths with an overall stoichiometric composition of RE-123, the result of this treatment is a RE-123 film with an atomistically random mixture of rare earths through the thickness of the film. This random structure gives rise to strains and atomic energy perturbations, which can pin magnetic flux in the superconductor. In the case of additives to the stoichiometric RE-123 composition, the result of this treatment is a RE-123 films with nanodot secondary phases or nanoparticles, which can pin magnetic flux in the superconductor. An example is shown in Fig. 6, where the nanodots are observed to be largely spherical and with maximum dimensions from 5 nm up to 100 nm. Smaller particles are likely to be present but are not resolved in this micrograph. As described in the examples that follow, the parameters of the treatment are selected to achieve optimal pinning properties.

The precursor composition can be used to prepare multi-layer superconductors using a wide variety of materials that can be used as the underlying layer on which the superconductor layer is formed.

It is generally preferable that the thin film of RE-123 material, e.g., superconducting RE-123, has chemical and structural compatibility with other materials in the multilayer or overall wire architecture. By "chemical compatibility" is meant that the RE-123 materials do not undergo property-degrading chemical interactions between alternating layers or with the substrate. By "structural compatibility" is meant that the RE-123 materials have a substantially similar lattice structure between alternating layers or with the substrate. Well known buffer layers can be used between the substrate and the RE-123 materials to assure chemical and structural compatibility.

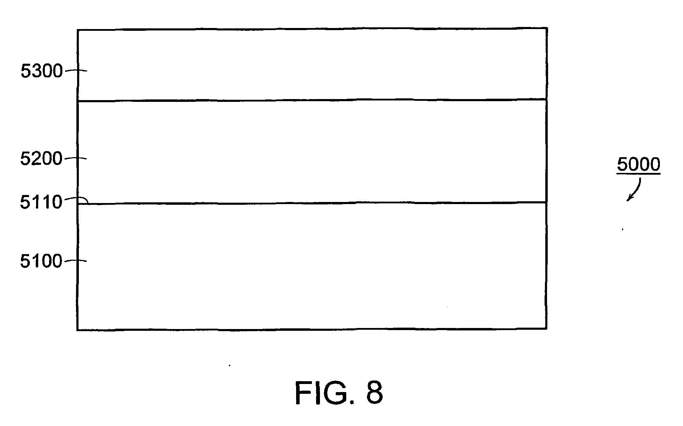

Fig. 8 is a cross-sectional view of a superconductor article 5000 having a substrate 5100 with surface 5110, a buffer layer 5200, and a superconductor layer 5300.

Preferably, surface 5110 has a relatively well defined crystallographic orientation. For example, surface 5110 can be a biaxially textured surface (e.g., a (113)[211] surface) or a cube textured surface (e.g., a (100)[011] surface or a (100)[001] surface). Preferably, the peaks in an X-ray diffraction pole figure of surface 110 have a FWHM of less than about 20° (e.g., less than about 15°, less than about 10°, or from about 5° to about 10°).

Surface 5110 can be prepared, for example, by rolling and annealing. Surface 5110 can also be prepared using vacuum processes, such as ion beam assisted deposition, inclined substrate deposition and other vacuum techniques known in the art to form a biaxially textured surface on, for example, a randomly oriented polycrystalline surface. In certain embodiments (e.g., when ion beam assisted deposition is used), surface 5110 of substrate 5100 need not be textured (e.g., surface 5110 can be randomly oriented polycrystalline, or surface 5110 can be amorphous).

Substrate 5100 can be formed of any material capable of supporting a buffer layer stack and/or a layer of superconductor material. Examples of substrate materials that can be used as substrate 5100 include for example, metals and/or alloys, such as nickel, silver, copper, zinc, aluminum, iron, chromium, vanadium, palladium, molybdenum and/or their alloys. In some embodiments, substrate 5100 can be formed of a superalloy. In certain embodiments, substrate 5100 can be in the form of an object having a relatively large surface area (e.g., a tape or a wafer). In these embodiments, substrate 5100 is preferably formed of a relatively flexible material.

In some of these embodiments, the substrate is a binary alloy that contains two of the following metals: copper, nickel, chromium, vanadium, aluminum, silver, iron, palladium, molybdenum, tungsten, gold and zinc. For example, a binary alloy can be formed of nickel and chromium (e.g., nickel and at most 20 atomic percent chromium, nickel and from about five to about 18 atomic percent chromium, or nickel and from about 10 to about 15 atomic percent chromium). As another example, a binary alloy can be formed of nickel and copper (e.g., copper and from about five to about 45 atomic percent nickel, copper and from about 10 to about 40 atomic percent nickel, or copper and from about 25 to about 35 atomic percent nickel). As a further example, a binary alloy can contain nickel and tungsten (e.g., from about one atomic percent tungsten to about 20 atomic percent tungsten, from about two atomic percent tungsten to about 10 atomic percent tungsten, from about three atomic percent tungsten to about seven atomic percent tungsten, about five atomic percent tungsten). A binary alloy can further include relatively small amounts of impurities (e.g., less than about 0.1 atomic percent of impurities, less than about 0.01 atomic percent of impurities, or less than about 0.005 atomic percent of impurities).

In certain of these embodiments, the substrate contains more than two metals (e.g., a ternary alloy or a quarternary alloy). In some of these embodiments, the alloy can contain one or more oxide formers (e.g., Mg, Al, Ti, Cr, Ga, Ge, Zr, Hf, Y, Si, Pr, Eu, Gd, Tb, Dy, Ho, Lu, Th, Er, Tm, Be, Ce, Nd, Sm, Yb and/or La, with Al being the preferred oxide former), as well as two of the following metals: copper, nickel, chromium, vanadium, aluminum, silver, iron, palladium, molybdenum, gold and zinc. In certain of these embodiments, the alloy can contain two of the following metals: copper, nickel, chromium, vanadium, aluminum, silver, iron, palladium, molybdenum, gold and zinc, and can be substantially devoid of any of the aforementioned oxide formers.

In embodiments in which the alloys contain an oxide former, the alloys can contain at least about 0.5 atomic percent oxide former (e.g., at least about one atomic percent oxide former, or at least about two atomic percent oxide former) and at most about 25 atomic percent oxide former (e.g., at most about 10 atomic percent oxide former, or at most about four atomic percent oxide former). For example, the alloy can include an oxide former (e.g., at least about 0.5 aluminum), from about 25 atomic percent to about 55 atomic percent nickel (e.g., from about 35 atomic percent to about 55 atomic percent nickel, or from about 40 atomic percent to about 55 atomic percent nickel) with the balance being copper. As another example, the alloy can include an oxide former (e.g., at least about 0.5 atomic aluminum), from about five atomic percent to about 20 atomic percent chromium (e.g., from about 10 atomic percent to about 18 atomic percent chromium, or from about 10 atomic percent to about 15 atomic percent chromium) with the balance being nickel. The alloys can include relatively small amounts of additional metals (e.g., less than about 0.1 atomic percent of additional metals, less than about 0.01 atomic percent of additional metals, or less than about 0.005 atomic percent of additional metals).

A substrate formed of an alloy can be produced by, for example, combining the constituents in powder form, melting and cooling or, for example, by diffusing the powder constituents together in solid state. The alloy can then be formed by deformation texturing (e.g, annealing and rolling, swaging, extrusion and/or drawing) to form a textured surface (e.g., biaxially textured or cube textured). Alternatively, the alloy constituents can be stacked in a jelly roll configuration, and then deformation textured. In some embodiments, a material with a relatively low coefficient of thermal expansion (e.g, Nb, Mo, Ta, V, Cr, Zr, Pd, Sb, NbTi, an intermetallic such as NiAl or Ni₃Al, or mixtures thereof) can be formed into a rod and embedded into the alloy prior to deformation texturing.

In some embodiments, stable oxide formation at surface 5110 can be mitigated until a first epitaxial (for example, buffer) layer is formed on the biaxially textured alloy surface, using an intermediate layer disposed on the surface of the substrate. Intermediate layers suitable for use in the present invention include those epitaxial metal or alloy layers that do not form surface oxides when exposed to conditions as established by P02 and temperature required for the initial growth of epitaxial buffer layer films. In addition, the buffer layer acts as a barrier to prevent substrate element(s) from migrating to the surface of the intermediate layer and forming oxides during the initial growth of the epitaxial layer. Absent such an intermediate layer, one or more elements in the substrate would be expected to form thermodynamically stable oxide(s) at the substrate surface which could significantly impede the deposition of epitaxial layers due to, for example, lack of texture in this oxide layer.

In some of these embodiments, the intermediate layer is transient in nature. "Transient," as used herein, refers to an intermediate layer that is wholly or partly incorporated into or with the biaxially textured substrate following the initial nucleation and growth of the epitaxial film. Even under these circumstances, the intermediate layer and biaxially textured substrate remain distinct until the epitaxial nature of the deposited film has been established. The use of transient intermediate layers may be preferred when the intermediate layer possesses some undesirable property, for example, the intermediate layer is magnetic, such as nickel.

Exemplary intermediate metal layers include nickel, gold, silver, palladium, and alloys thereof. Additional metals or alloys may include alloys of nickel and/or copper. Epitaxial films or layers deposited on an intermediate layer can include metal oxides, chalcogenides, halides, and nitrides. In some embodiments, the intermediate metal layer does not oxidize under epitaxial film deposition conditions.

Care should be taken that the deposited intermediate layer is not completely incorporated into or does not completely diffuse into the substrate before nucleation and growth of the initial buffer layer structure causes the epitaxial layer to be established. This means that after selecting the metal (or alloy) for proper attributes such as diffusion constant in the substrate alloy, thermodynamic stability against oxidation under practical epitaxial buffer layer growth conditions and lattice matching with the epitaxial layer, the thickness of the deposited metal layer has to be adapted to the epitaxial layer deposition conditions, in particular to temperature.

Deposition of the intermediate metal layer can be done in a vacuum process such as evaporation or sputtering, or by electro-chemical means such as electroplating (with or without electrodes). These deposited intermediate metal layers may or may not be epitaxial after deposition (depending on substrate temperature during deposition), but epitaxial orientation can subsequently be obtained during a post-deposition heat treatment.

In certain embodiments, sulfur can be formed on the surface of the intermediate layer. The sulfur can be formed on the surface of the intermediate layer, for example, by exposing the intermediate layer to a gas environment containing a source of sulfur (e.g., H₂S, a tantalum foil or a silver foil) and hydrogen (e.g., hydrogen, or a mix of hydrogen and an inert gas, such as a 5% hydrogen/argon gas mixture) for a period of time (e.g., from about 10 seconds to about one hour, from about one minute to about 30 minutes, from about five minutes to about 15 minutes). This can be performed at elevated temperature (e.g., at a temperature of from about 450°C to about 1100°C, from about 600°C to about 900°C, 850°C).

The pressure of the hydrogen (or hydrogen/inert gas mixture) can be relatively low (e.g., less than about 0.13kPa (about one Torr), less than about 1 x10⁻⁴kPa (about 1 x10⁻³ Torr), less than about 1x10⁻⁷kPa (about 1x10⁻⁶ Torr)) or relatively high (e.g., greater than about 0.13kPa (about 1 Torr), greater than about 13.33kPa (about 100 Torr), greater than about 101.33kPa (about 760 Torr)).

Without wishing to be bound by theory, it is believed that exposing the textured substrate surface to a source of sulfur under these conditions can result in the formation of a superstructure (e.g., a c(2x2) superstructure) of sulfur on the textured substrate surface. It is further believed that the superstructure can be effective in stabilizing (e.g., chemically and/or physically stabilizing) the surface of the intermediate layer.

While one approach to forming a sulfur superstructure has been described, other methods of forming such superstructures can also be used. For example, a sulfur superstructure (e.g., S c(2x2)) can be formed by applying an appropriate organic solution to the surface of the intermediate layer by heating to an appropriate temperature in an appropriate gas environment.

Moreover, while formation of a sulfur superstructure on the surface of the intermediate layer has been described, it is believed that other superstructures may also be effective in stabilizing (e.g., chemically and/or physically stabilizing) the surface. For example, it is believed that an oxygen superstructure, a nitrogen superstructure, a carbon superstructure, a potassium superstructure, a cesium superstructure, a lithium superstructure or a selenium superstructure disposed on the surface may be effective in enhancing the stability of the surface

In some embodiments, a buffer layer can be formed using ion beam assisted deposition (IBAD). In this technique, a buffer layer material is evaporated using, for example, electron beam evaporation, sputtering deposition, or pulsed laser deposition while an ion beam (e.g., an argon ion beam) is directed at a smooth amorphous surface of a substrate onto which the evaporated buffer layer material is deposited.

For example, the buffer layer can be formed by ion beam assisted deposition by evaporating a buffer layer material having a rock-salt like structure (e.g., a material having a rock salt structure, such as an oxide, including MgO, or a nitride) onto a smooth, amorphous surface (e.g., a surface having a root mean square roughness of less than about 100 Angstroms) of a substrate so that the buffer layer material has a surface with substantial alignment (e.g., about 13° or less), both in-plane and out-of-plane.

The conditions used during deposition of the buffer layer material can include, for example, a substrate temperature of from about 0°C to about 750°C (e.g., from about 0°C to about 400°C, from about room temperature to about 750°C, from about room temperature to about 400°C), a deposition rate of from about 1.0 Angstrom per second to about 4.4 Angstroms per second, an ion energy of from about 200 eV to about 1200 eV, and/or an ion flux of from about 110 microamperes per square centimeter to about 120 microamperes per square centimeter.

In some embodiments, when using IBAD, the substrate is formed of a material having a polycrystalline, non-amorphous base structure (e.g., a metal alloy, such as a nickel alloy) with a smooth amorphous surface formed of a different material (e.g., Si₃N₄).

In certain embodiments, a plurality of buffer layers can be deposited by epitaxial growth on an original IBAD surface. Each buffer layer can have substantial alignment (e.g., about 13° or less), both in-plane and out-of-plane.

A buffer material can be prepared using solution phase techniques, including metalorganic deposition, such as disclosed in, for example, S.S. Shoup et al., J. Am. Cer. Soc., vol. 81, 3019; D. Beach et al., Mat. Res. Soc. Symp. Proc., vol. 495, 263 (1988); M. Paranthaman et al., Superconductor Sci. Tech., vol. 12, 319 (1999); D.J. Lee et al., Japanese J. Appl. Phys., vol. 38, L178 (1999) and M.W. Rupich et al., I.E.E.E. Trans. on Appl. Supercon. vol. 9, 1527. In certain embodiments, solution coating processes can be used for deposition of one or a combination of any of the oxide layers on textured substrates; however, they can be particularly applicable for deposition of the initial (seed) layer on a textured metal substrate. The role of the seed layer is to provide 1) protection of the substrate from oxidation during deposition of the next oxide layer when carried out in an oxidizing atmosphere relative to the substrate (for example, magnetron sputter deposition of yttria-stabilized zirconia from an oxide target); and 2) an epitaxial template for growth of subsequent oxide layers. In order to meet these requirements, the seed layer should grow epitaxially over the entire surface of the metal substrate and be free of any contaminants that may interfere with the deposition of subsequent epitaxial oxide layers.

The formation of oxide buffer layers can be carried out so as to promote wetting of an underlying substrate layer. Additionally, in particular embodiments, the formation of metal oxide layers can be carried out using metal alkoxide precursors (for example, "sol gel" precursors), in which the level of carbon contamination can be greatly reduced over other known processes using metal alkoxide precursors.

If the substrate underlying an oxide layer is insufficiently covered by a metal salt solution used to make the oxide layer, then the oxide layer will not provide the desired protection of the substrate from oxidation during deposition of the subsequent oxide layers when carried out in an oxidizing atmosphere relative to the substrate and will not provide a complete template for the epitaxial growth of subsequent layers. By heating a sol gel film, and thereby allowing the precursor to flow into the substrate grain boundary areas, complete coverage can result. The heating can be relatively low temperature, for example, from about 80°C to about 320°C, for example, from about 100°C to about 300°C, or from about 100°C to about 200°C. Such temperatures can be maintained from about 1 to about 60 minutes, for example, from about 2 to about 45 minutes, or from about 15 to about 45 minutes. The heating step can also be carried out using higher temperatures for a shorter time, for example, a film can be processed within two minutes at a temperature of 300°C.

This heating step can be carried out after, or concurrently with, the drying of excess solvent from the sol gel film. It must be carried out prior to decomposition of the film, however.

The carbon contamination accompanying conventional oxide film preparation in a reducing environment (e.g., 4%H2-Ar) is believed to be the result of an incomplete removal of the organic components of the film. The presence of carbon-containing contaminants CₓH_{y} and CₐH_{b}O_{c} in or near the oxide layer can be detrimental, since they can alter the epitaxial deposition of subsequent oxide layers. Additionally, it is likely that the trapped carbon-containing contaminants buried in the film can be oxidized during the processing steps for subsequent oxide layers, which can utilize oxidizing atmospheres. The oxidation of the carbon-containing contaminants can result in CO₂ formation, and the subsequent blistering of the film, and possible delamination of the film, or other defects in the composite structure. Thus, it is undesirable to allow carbon-containing contaminants arising from metal alkoxide decomposition to become oxidized only after the oxide layer is formed. Preferably, the carbon-containing contaminants are oxidized (and hence removed from the film structure as CO₂) as the decomposition occurs. Also the presence of carbon-containing species on or near film surfaces can inhibit the epitaxial growth of subsequent oxide layers.

According to particular embodiments, after coating a metal substrate or buffer layer, the metal salt solution can be air dried, and then heated in an initial decomposition step. Alternatively, the metal salt solution can be directly heated in an initial decomposition step, under an atmosphere that is reducing relative to the metal substrate. Once the oxide layer initially nucleates on the metal substrate in the desired epitaxial orientation, the oxygen level of the process gas is increased, for example, by adding water vapor or oxygen. The nucleation step requires from about 5 minutes to about 30 minutes to take place under typical conditions.

In certain embodiments, an epitaxial buffer layer can be formed using a low vacuum vapor deposition process (e.g., a process performed at a pressure of at least about 1x10⁻⁴kPa (about 1 x10⁻³Torr)). The process can include forming the epitaxial layer using a relatively high velocity and/or focused gas beam of buffer layer material.

The buffer layer material in the gas beam can have a velocity of greater than about one meter per second (e.g., greater than about 10 meters per second or greater than about 100 meters per second). At least about 50% of the buffer layer material in the beam can be incident on the target surface (e.g., at least about 75% of the buffer layer material in the beam can be incident on the target surface, or at least about 90% of the buffer layer material in the beam can be incident on the target surface).

The method can include placing a target surface (e.g., a substrate surface or a buffer layer surface) in a low vacuum environment, and heating the target surface to a temperature which is greater than the threshold temperature for forming an epitaxial layer of the desired material on the target surface in a high vacuum environment (e.g., less than about 1x10⁻⁴kPa (about 1 x10⁻³ Torr), such as less than about 1 x10⁻⁵kPa (about 1 x10⁻⁴ Torr) under otherwise identical conditions. A gas beam containing the buffer layer material and optionally an inert carrier gas is directed at the target surface at a velocity of at least about one meter per second. A conditioning gas is provided in the low vacuum environment. The conditioning gas can be contained in the gas beam, or the conditioning gas can be introduced into the low vacuum environment in a different manner (e.g., leaked into the environment). The conditioning gas can react with species (e.g., contaminants) present at the target surface to remove the species, which can promote the nucleation of the epitaxial buffer layer.

The epitaxial buffer layer can be grown on a target surface using a low vacuum (e.g., at least about 1x10⁻⁴kPa (about 1x10⁻³ Torr), at least about 0.01 kPa (about 0.1 Torr), or at least about 0.13kPa (about 1 Torr) at a surface temperature below the temperature used to grow the epitaxial layer using physical vapor deposition at a high vacuum (e.g., at most about 1x10⁻⁵kPa (about 1x10⁻⁴ Torr)). The temperature of the target surface can be, for example, from about 25°C to about 800°C (e.g., from about 500°C to about 800°C, or from about 500°C to about 650°C).

The epitaxial layer can be grown at a relatively fast rate, such as, for example, at least about 50 Angstroms per second.

In alternate embodiments, an epitaxial buffer layer can be deposited by sputtering from a metal or metal oxide target at a high throughput. Heating of the substrate can be accomplished by resistive heating or bias and electric potential to obtain an epitaxial morphology. A deposition dwell may be used to form an oxide epitaxial film from a metal or metal oxide target.

The oxide layer typically present on substrates can be removed by exposure of the substrate surface to energetic ions within a reducing environment, also known as Ion Beam etching. Ion Beam etching can be used to clean the substrate prior to film deposition, by removing residual oxide or impurities from the substrate, and producing an essentially oxide-free preferably biaxially textured substrate surface. This improves the contact between the substrate and subsequently deposited material. Energetic ions can be produced by various ion guns, for example, which accelerate ions such as Ar+ toward a substrate surface. Preferably, gridded ion sources with beam voltages greater than 150 ev are utilized. Alternatively, a plasma can be established in a region near the substrate surface. Within this region, ions chemically interact with a substrate surface to remove material from that surface, including metal oxides, to produce substantially oxide-free metal surface.

Another method to remove oxide layers from a substrate is to electrically bias the substrate. If the substrate tape or wire is made negative with respect to the anode potential, it will be subjected to a steady bombardment by ions from the gas prior to the deposition (if the target is shuttered) or during the entire film deposition. This ion bombardment can clean the wire or tape surface of absorbed gases that might otherwise be incorporated in the film and also heat the substrate to elevated deposition temperatures. Such ion bombardment can be further advantageous by improving the density or smoothness of the epitaxial film.

Upon formation of an appropriately textured, substantially oxide-free substrate surface, deposition of a buffer layer can begin. One or more buffer layers, each including a single metal or oxide layer, can be used. In some embodiments, the substrate is allowed to pass through an apparatus adapted to carry out steps of the deposition method of these embodiments. For example, if the substrate is in the form of a wire or tape, the substrate can be passed linearly from a payout reel to a take-up reel, and steps can be performed on the substrate as it passes between the reels.

According to some embodiments, substrate materials are heated to elevated temperatures which are less than about 90% of the melting point of the substrate material but greater than the threshold temperature for forming an epitaxial layer of the desired material on the substrate material in a vacuum environment at the predetermined deposition rate. In order to form the appropriate buffer layer crystal structure and buffer layer smoothness, high substrate temperatures are generally preferred. Typical lower limit temperatures for the growth of oxide layers on metal are approximately 200°C to 800°C, preferably 500°C to 800°C, and more preferably, 650°C to 800°C. Various well-known methods such as radiative heating, convection heating, and conduction heating are suitable for short (2 cm to 10 cm) lengths of substrate, but for longer (1m to 100 m) lengths, these techniques may not be well suited. Also to obtain desired high throughput rates in a manufacturing process, the substrate wire or tape must be moving or transferring between deposition stations during the process. According to particular embodiments, the substrates are heated by resistive heating, that is, by passing a current through the metal substrate, which is easily scaleable to long length manufacturing processes. This approach works well while instantaneously allowing for rapid travel between these regions. Temperature control can be accomplished by using optical pyrometers and closed loop feedback systems to control the power supplied to the substrate being heated. Current can be supplied to the substrate by electrodes which contact the substrate in at least two different segments of the substrate. For example, if the substrate, in the form of a tape or wire, is passed between reels, the reels themselves could act as electrodes. Alternatively, if guides are employed to transfer the substrate between reels, the guides could act as electrodes. The electrodes could also be completely independent of any guides or reels as well. In some embodiments, current is applied to the tape between current wheels.

In order that the deposition is carried out on tape that is at the appropriate temperature, the metal or oxide material that is deposited onto the tape is desirably deposited in a region between the current wheels. Because the current wheels can be efficient heat sinks and can thus cool the tape in regions proximate to the wheels, material is desirably not deposited in regions proximate to the wheels. In the case of sputtering, the charged material deposited onto the tape is desirably not influenced by other charged surfaces or materials proximate to the sputter flux path. For this reason, the sputter chamber is preferably configured to place components and surfaces which could influence or deflect the sputter flux, including chamber walls, and other deposition elements, in locations distant from the deposition zone so that they do not alter the desired linear flux path and deposition of metal or metal oxide in regions of the tape at the proper deposition temperature.

In certain embodiments, a buffer layer (and/or a layer of superconductor material) can be conditioned (e.g., thermally conditioned and/or chemically conditioned) so a subsequent layer is formed on a conditioned surface. The conditioned surface of the material layer can be biaxially textured (e.g., (113)[211] or (100)[011]) or cube textured (e.g., (100)[001]), have peaks in an X-ray diffraction pole figure that have a full width at half maximum of less than about 20° (e.g., less than about 15°, less than about 10°, or from about 5° to about 10°), be smoother than before conditioning as determined by high resolution scanning electron microscopy or atomic force microscopy, have a relatively high density, have a relatively low density of impurities, exhibit enhanced adhesion to other material layers (e.g., a superconductor layer or a buffer layer) and/or exhibit a relatively small rocking curve width as measured by x-ray diffraction.

"Chemical conditioning" as used herein refers to a process which uses one or more chemical species (e.g., gas phase chemical species and/or solution phase chemical species) to affect changes in the surface of a material layer, such as a buffer layer or a superconductor material layer, so that the resulting surface exhibits one or more of the above noted properties.

"Thermal conditioning" as used herein refers to a process which uses elevated temperature, with or without chemical conditioning, to affect changes in the surface of a material layer, such as a buffer layer or a superconductor material layer, so that the resulting surface exhibits one or more of the above noted properties. Thermal conditioning can be performed with or without the use of chemical conditioning. Preferably, thermal conditioning occurs in a controlled environment (e.g., controlled gas pressure, controlled gas environment and/or controlled temperature).

Thermal conditioning can include heating the surface of the buffer layer to a temperature at least about 5°C above the deposition temperature or the crystallization temperature of the underlying layer (e.g., from about 15°C to about 500°C above the deposition temperature or the crystallization temperature of the underlying layer, from about 75°C to about 300°C above the deposition temperature or the crystallization temperature of the underlying layer, or from about 150°C to about 300°C above the deposition temperature or the crystallization temperature of the underlying layer). Examples of such temperatures are from about 500°C to about 1200°C (e.g., from about 800°C to about 1050°C). Thermal conditioning can be performed under a variety of pressure conditions, such as above atmospheric pressure, below atmospheric pressure, or at atmospheric pressure. Thermal conditioning can also be performed using a variety of gas environments, such as a chemical conditioning environment (e.g., an oxidizing gas environment, a reducing gas environment) or an inert gas environment.

"Deposition temperature" as used herein refers to the temperature at which the layer being conditioned was deposited.

"Crystallization temperature" as used herein refers to the temperature at which a layer of material (e.g., the underlying layer) takes on a crystalline form.

Chemical conditioning can include vacuum techniques (e.g., reactive ion etching, plasma etching and/or etching with fluorine compounds, such as BF3 and/or CF4). Chemical conditioning techniques are disclosed, for example, in Silicon Processing for the VLSI Era, Vol. 1, eds. S. Wolf and R.N. Tanber, pp. 539-574, Lattice Press, Sunset Park, CA, 1986.

Alternatively or additionally, chemical conditioning can involve solution phase techniques, such as disclosed in Metallurgy and Metallurgical Engineering Series, 3d ed., George L. Kehl, McGraw-Hill, 1949. Such techniques can include contacting the surface of the underlying layer with a relatively mild acid solution (e.g., an acid solution containing less about 10 percent acid, less than about two percent acid, or less than about one percent acid). Examples of mild acid solutions include perchloric acid, nitric acid, hydrofluoric acid, hydrochloric acid, acetic acid and buffered acid solutions. In one embodiment, the mild acid solution is about one percent aqueous nitric acid. In certain embodiments, bromide-containing and/or bromine-containing compositions (e.g., a liquid bromine solution) can be used to condition the surface of a buffer layer or a superconductor layer.

Materials that can be used for buffer layers include, for example, CeO₂, Y₂O₃, TbOₓ, GaOₓ, YSZ, LaAlO₃, SrTiO₃, Gd₂O₃, LaNiO₃, LaCuO₃, SrTuO₃, NdGaO₃, NdAlO₃, MgO, AlN, NbN, TiN, VN and ZrN.

In general, the thickness of layer 5200 can be varied as desired. In some embodiments, layer 200 is from about 0.01 micrometer to about five micrometers thick (e.g., from about 0.02 micrometer to about one micrometer thick, from about 0.02 micrometer to about 0.75 micrometer thick).

In certain embodiments, multiple buffer layers are used. Various combinations of buffer layer materials and/or buffer layer thicknesses can be used. In some embodiments, a layer of Y₂O₃ or CeO₂ (e.g., from about 20 nanometers thick to about 50 nanometers thick) is deposited (e.g., using electron beam evaporation) onto surface 110. A layer of YSZ (e.g., from about 0.1 micrometer thick to about 0.5 micrometer thick) is deposited on the Y₂O₃ or CeO₂ surface using sputtering (e.g., magnetron sputtering). A CeO₂ layer (e.g., about 20 nanometers thick) is deposited (e.g., using magnetron sputtering) onto the YSZ surface. The surface of one or more of these layers can be chemically conditioned and/or thermally conditioned.

While certain architectures for multi-layer articles have been described, the invention is not limited in this sense. Other architectures may also be used. For example, Fig. 8 shows a cross-sectional view of an embodiment of article 6000 that includes a cap layer 5400 between buffer layer 5200 and superconductor layer 5300. Cap layer 5400 can be formed of a material (e.g., a ceramic oxide) that provides a template for the formation (e.g., the epitaxial deposition) of layer 5300 (e.g., the epitaxial deposition of Y123 Exemplary cap materials include CeO₂, Y₂O₃ and SrTiO₃.

Various combinations of buffer layers and superconductor material layers can be used. For example, multiple buffer layers can be disposed between the substrate and the superconductor layer. As another example, multiple layers of superconductor material can be used. As an additional example, combinations of buffer layers and superconductor layers (e.g., alternating buffer layers and superconductor layers) can be used.

Other arrangements can also be used.

The present invention is more particularly described in the following examples, which are intended as illustrative only, since numerous modifications and variations will be apparent to those skilled in the art.

### Example 1. Preparation of Y123 Film.

A comparative film of Y123 without pinning sites was prepared.

A Y123 precursor solution was prepared by dissolving about 0.83 grams of Y(CF₃CO₂)₃, about 1.60 grams of Ba(CF₃CO₂)₂ and about 1.28 grams of Cu(C₂H₅CO₂)₂ in about 4.85 ml. of methanol (CH₃OH) and about 0.15 ml of propionic acid (C₂H₆CO₂). The final volume of the solution was adjusted to about 5 ml with methanoL

The precursor solution was deposited by a slot die coating technique on a length (20 cm to 10 meter) of 1 cm wide biaxially textured oxide buffered metallic substrate with the structure Ni(5at%)W/Y₂O₃/YSZ/CeO₂. A sufficient quantity of precursor solution was deposited to produce about a 0.8 µm thick YBa₂Cu₃O₇₋ₓ film.

The coated sample was decomposed to an intermediate metal oxyfluoride film by heating, in a 2.25" diameter tube furnace, from room temperature to about 200°C at a rate of about 15°C per minute, then from about 200°C to about 250 C at a rate of about 0.9°C per minute and then from about 250°C to about 400°C at a rate of about 5°C per minute in a flowing gas environment haying a total gas pressure of about (101.33 kPa (about 760 Torr) (water vapor pressure of about 3.19 kPa (about 24 Torr) and balance oxygen).

The metal oxyfluoride film was then heat treated to form an oxide superconductor. A short length (1-2 cm) of the intermediate film was heated in a tube furnace to about 785°C at a rate of about 200°C per minute and held for about 30 min in an environment having a total gas pressure of about 0.03kPa (about 240 mTorr) (water vapor pressure of about 0.01 kPa (about 90 mTorr), and oxygen gas pressure of about 0.02kPa (about 150 mTorr)). After 30 min holding, the H₂O vapor removed from the gas environment and the film was then cooled to room temperature in about 0.02kPa (about 150 mTorr) O₂. The film was then coated, by sputtering, with 2 µm Ag layer and annealed at 550°C in 1 atm O₂ for 1 hr and cooled to room temperature.

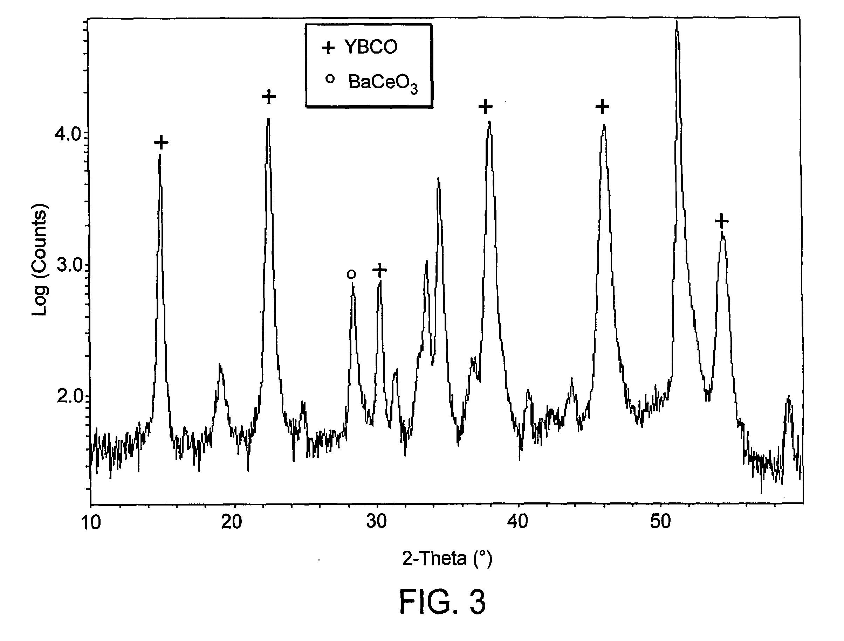

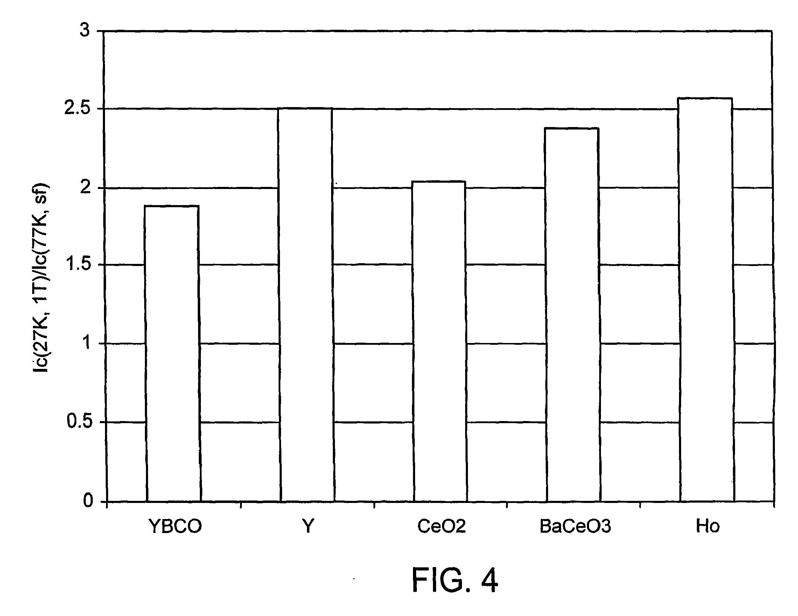

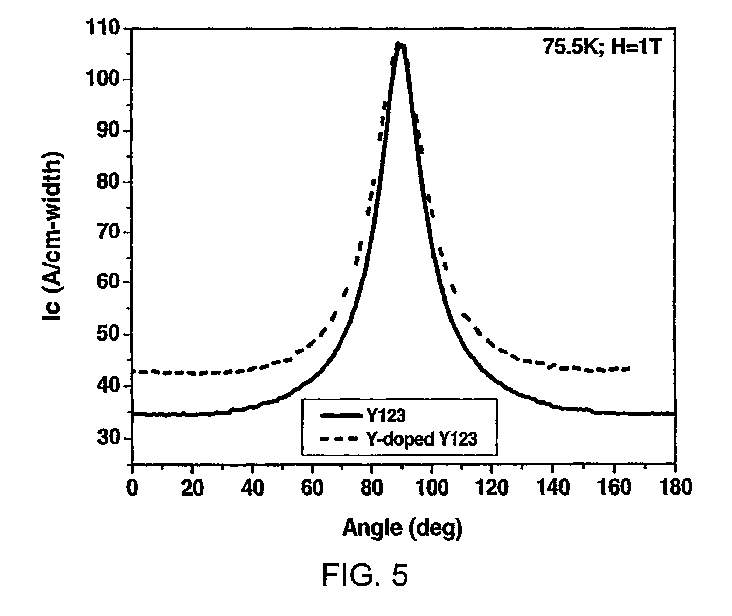

The resulting film and was about 0.8 micron thick. The x-ray diffraction pattern of the final film (Fig. 3) showed the presence of predominantly (001) textured YBa₂Cu₃O₇₋ₓ and a small amount of a BaCeO₃ interfacial reaction product. The critical current of the final film was measured by four probe method under different magnetic field at 77K and 27K, respectively. The ratio of the critical current at 27K in a 1T field (perpendicular to the tape) to the critical current at 77K in self field is shown in Fig. 4. The critical current of the film in a 1 Tesla magnetic field is shown in Fig. 5 as a function of the angle of the magnetic field relative to the planar face of the film.

### Example 2. Preparation of Y123 film with excess yttrium.

A Y123 film with yttrium-containing nanodots or nanoparticles was prepared.

A Y123 precursor solution was prepared by dissolving about 0.98 grams of Y(CF₃CO₂)₃, about 1.60 grams of Ba(CF₃CO₂)₂, about 1.28 grams of Cu(C₂H₅CO₂)₂ and about 0.025 grams of Ce(CH₃CO₂)₃ in about 4.85 ml. of methanol (CH₃OH) and about 0.15 ml of propionic acid (C₂H₆CO₂). The final volume of the solution was adjusted to about 5 ml with methanol.

The precursor solution was deposited by a slot die coating technique on a length (20 cm to 10 meter) of 1 cm wide biaxially textured oxide buffered metallic substrate with the structure Ni(5at%)W/Y₂O₃/YSZ/CeO₂. A sufficient quantity of precursor solution was deposited to produce about a 0.8 µm thick YBa₂Cu₃O₇₋ₓ (Y123) film.

The coated sample was decomposed to an intermediate metal oxyfluoride film by heating, in a 2.25" diameter tube furnace, from room temperature to about 200°C at a rate of about 15°C per minute, then from about 200°C to about 250°C at a rate of about 0.9°C per minute and then from about 250°C to about 400°C at a rate of about 5°C per minute in a flowing gas environment having a total gas pressure of about (101.33 kPa (about 760 Torr) (water vapor pressure of about 3.19 kPa (about 24 Torr) and balance oxygen).

A short length (1-2 cm) of the intermediate film was heated in a tube furnace to about 770°C at a rate of about 200 °C per minute and held for about 30 min in an environment having a total gas pressure of about 0.03kPa (about 240 mTorr) (water vapor pressure of about 0.01 kPa (about 90 mTorr), and oxygen gas pressure of about 0.02kPa (about 150 mTorr)). After 30 min holding, the H₂O vapor removed from the gas environment and the film was then cooled to room temperature in about 0.02kPa (about 150 mTorr) O₂. The film was then coated, by sputtering, with 2 µm Ag layer and annealed at 550°C in 1 atm O₂ for 1 hr and cooled to room temperature.

The resulting film was about 0.8 micron thick. The critical current of the final film was measured by four probe method under different magnetic field at 77 K and 27 K, respectively. The ratio of the critical current at 27 K in a 1 T field (perpendicular to the tape) to the critical current at 77 K in self field is shown in Fig.4. A transmission electron micrograph (TEM) of the sample (Fig 6) shows presence of numerous nanometer-sized particles (nanodbts) with the general composition of Y₂O₃ or Y₂Cu₂O₅ throughout the YBa₂Cu₃O₇₋ₓ matrix. The critical current of the film in a 1 Tesla magnetic field is shown in Fig. 5 as a function of the angle of the magnetic field relative to the planar face of the film. The film shows better retention of the critical current at a broad range of orientations of the magnetic field compared to the film prepared in Example 1.

### Example 3. Preparation of Y123 film containing BaCeO₃.

A Y123 film with BaCeO₃-containing nanodots or nanoparticles was prepared.

A Y123 precursor solution was prepared by dissolving about 0.83 grams of Y(CF₃CO₂)₃, about 1.68 grams of Ba(CF₃CO₂)₂, about 1.28 grams of Cu(C₂H₅CO₂)₂ and about 0.025 grams of Ce(CH₃CO₂)₃ in about 4.85 ml. of methanol (CH₃OH) and about 0.15 ml of propionic acid (C₂H₆CO₂). The final volume of the solution was adjusted to about 5 ml with methanol.

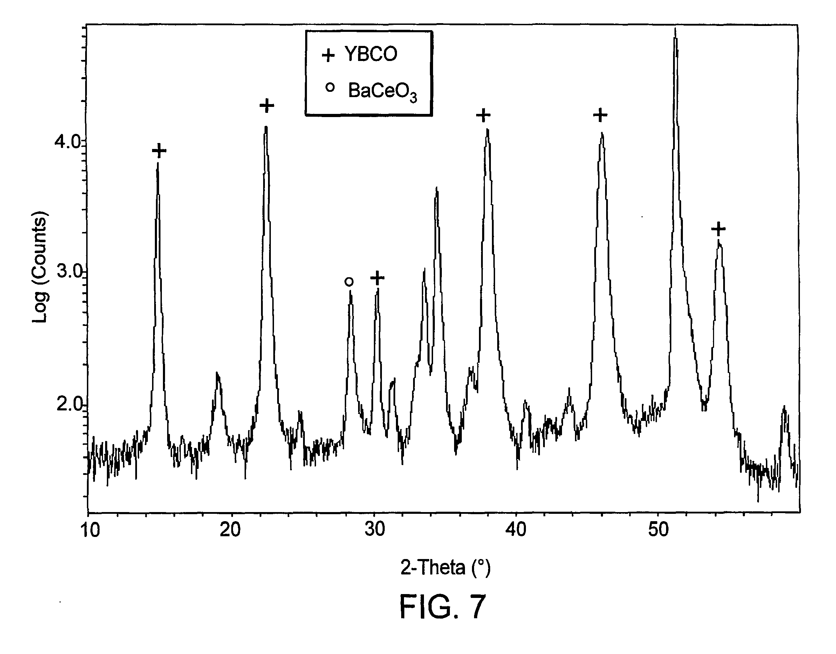

The precursor was coated and decomposed, processed and coated with Ag as described in Example 1. The resulting film and was about 0.8 micron thick. The x-ray diffraction pattern of the final film (Fig 7) showed the presence of was (001) textured YBa₂Cu₃O₇₋ₓ and BaCeO₃.

The critical current of the final film was measured by four probe method under different magnetic field at 77K and 27K, respectively. The ratio of the critical current at 27K in a 1T field (perpendicular to the tape) to the critical current at 77K in self field is shown in Fig.4.

### Example 4. Preparation of Y123 film containing CeO₂.

A Y123 film with CeO₂-containing nanodots or nanoparticles was prepared.

A Y123 precursor solution was prepared by dissolving about 0.83 grams of Y(CF₃CO₂)₃, about 1.60 grams of Ba(CF₃CO₂)₂, about 1.28 grams of Cu(C₂H₅CO₂)₂ and about 0.025 grams of Ce(CH₃CO₂)₃ in about 4.85 ml. of methanol (CH₃OH) and about 0.15 ml of propionic acid (C₂H₆CO₂). The final volume of the solution was adjusted to about 5 ml with methanol.

The precursor was coated and decomposed, processed and Ag coated as described in Example 1. The resulting film and was about 0.8 micron thick. The x-ray diffraction pattern of the final film showed the presence of was (001) textured YBa₂Cu₃O₇₋ₓ and BaCeO₃.

The critical current of the final film was measured by four probe method under different magnetic field at 77K and 27K, respectively. The ratio of the critical current at 27K in a 1T field (perpendicular to the tape) to the critical current at 77K in self field is shown in Fig.4.

### Example 5. Preparation of (Y, Ho)123 Film.

A holmium-doped Y123 film was prepared.

A precursor solution was prepared by dissolving about 0.75 grams of Y(CF₃CO₂)₃, about 0.06 grams of Ho(CH₃CO₂)₃,, about 1.60 grams of Ba(CF₃CO₂)₂ and about 1.28 grams of Cu(C₂H₅CO₂)₂ in about 4.85 ml. of methanol (CH₃OH) and about 0.15 ml of propionic acid (C₂H₆CO₂). The final volume of the solution was adjusted to about 5 ml with methanol

The precursor was coated, decomposed, processed and Ag coated as described in Example 1. The resulting film and was about 0.8 micron thick. The x-ray diffraction pattern of the final film showed the presence of was (001) textured Y(Ho)Ba₂Cu₃O₇₋ₓ.

The critical current of the final film was measured by four probe method under different magnetic field at 77K and 27K, respectively. The ratio of the critical current at 27K in a 1T field (perpendicular to the tape) to the critical current at 77K in self field is shown in Fig.4.

### Example 6. Preparation of Y123 film containing Ag.

A Y123 precursor solution was prepared by dissolving about 0.83 grams of Y(CF₃CO₂)₃, about 1.60 grams of Ba(CF₃CO₂)₂, about 1.28 grams of Cu(C₂H₅CO₂)₂ and about 0.02 gm of Ag(CF₃CO₂)₂ in about 4.85 mL of methanol (CH₃OH) and about 0.15 ml of propionic acid (C₂H₆CO₂). The final volume of the solution was adjusted to about 5 ml with methanoL

The precursor was coated, decomposed, processed and Ag coated as described in Example 1. The resulting film and was about 0.8 micron thick. The x-ray diffraction pattern of the final film showed the presence of was (001) textured YBa₂Cu₃O₇₋ₓ. Ag remains in the film as Ag particles, probably both within the grains and at the grain boundaries.

The following documents are hereby referred to: U.S. Patent No. 5,231,074, issued on July 27, 1993, and entitled "Preparation of Highly Textured Oxide Superconducting Films from MOD Precursor Solutions," U.S. Patent No. 6,022,832, issued February 8, 2000, and entitled "Low Vacuum Process for Producing Superconductor Articles with Epitaxial Layers," U.S. Patent No. 6,027,564, issued February 22, 2000, and entitled "Low Vacuum Process for Producing Epitaxial Layers," U.S. Patent No. 6,190,752, issued February 20, 2001, and entitled "Thin Films Having Rock-Salt-Like Structure Deposited on Amorphous Surfaces,' PCT Publication No. WO 00/58530, published on October 5, 2000, and entitled "Alloy Materials," PCT Publication No. WO/58044, published on October 5, 2000, and entitled "Alloy Materials," PCT Publication No. WO 99/17307, published on April 8,1999, and entitled "Substrates with Improved Oxidation Resistance," PCT Publication No. WO 99/16941, published on April 8, 1999, and entitled "Substrates for Superconductors," PCT Publication No. WO 98/58415, published on December 23, 1998, and entitled "Controlled Conversion of Metal Oxyfluorides into Superconducting Oxides," PCT Publication No. WO 01/11428, published on February 15, 2001, and entitled "Multi-Layer Articles and Methods of Making Same," PCT Publication No. WO 01108232, published on February 1, 2001, and entitled "Multi-Layer Articles And Methods Of Making Same," PCT Publication No. WO 01/08235, published on February 1, 2001, and entitled "Methods And Compositions For Making A Multi-Layer Article," PCT Publication No. WO 01/08236, published on February 1, 2001, and entitled "Coated Conductor Thick Film Precursor", PCT Publication No. WO 01108169, published on February 1, 2001, and entitled "Coated Conductors With Reduced A.C. Loss" PCT Publication No. WO 01/15245, published on March 1, 2001, and entitled "Surface Control Alloy Substrates And Methods Of Manufacture Therefor," PCT Publication No. WO 01/08170, published on February 1, 2001, and entitled "Enhanced Purity Oxide Layer Formation," PCT Publication No. WO 01/26164, published on April 12, 2001, and entitled "Control of Oxide Layer Reaction Rates," PCT Publication No. WO 01/26165, published on April 12, 2001, and entitled "Oxide Layer Method," PCT Publication No. WO 01/08233, published on February 1, 2001, and entitled "Enhanced High Temperature Coated Superconductors," PCT Publication No. WO 01/08231, published on February 1,2001, and entitled "Methods of Making A Superconductor," PCT Publication No. WO 02/35615, published on April 20, 2002, and entitled "Precursor Solutions and Methods of Using Same," U.S. Patent Application Serial No. 09/579,193, filed on May 26, 2000, and entitled, "Oxide Bronze Compositions And Textured Articles Manufactured In Accordance Therewith;" and U.S. Provisional Patent Application Serial No. 60/309,116, filed on July 31, 2001, and entitled "Multi-Layer Superconductors And Methods Of Making Same;" U.S. Patent Application Serial No. 10/208,134, filed on July 30, 2002, and entitled "Superconductor Methods and Reactor," and U.S. Provisional Patent Application Serial No. 60/308,957, filed on July 31, 2001, and entitled "Superconductor Methods and Reactors;" and U.S. Provisional Patent Application Serial No. 60/166,297, filed on Nov. 18, 1999, and entitled "Superconductor Articles and Compositions and Methods for Making Same," and commonly owned U.S. patent application Ser. No. 09/615,999, filed on July 14, 2000, and entitled "Superconductor Articles and Compositions and Methods for Making Same".

## Claims

1. A method for producing a thin film comprising:
disposing a precursor solution onto a substrate to form a precursor film, the precursor solution comprising:
precursor components to a rare earth element/alkaline earth metat/transition metal oxide comprising a salt of a rare earth element, a salt of an alkaline earth metal, and a salt of a transition metal in one or more solvents, wherein at least one of the salts is a fluoride-containing salt, and
a dopant component and/or an additive component,
wherein the dopant comprises a metal compound having a dopant metal capable of replacing one or more of the rare earth element and alkaline earth metal of the rare earth/alkaline earth metal/transition metal oxide, and wherein the additive component comprises one or more metal compounds capable of forming a second phase nanoparticle, either alone or in combination with one or more of the precursor components of the precursor solution; and
treating the precursor film to form an intermediate metal oxyfluoride film including the rare earth element, the alkaline earth metal, the transition metal and the dopant metal and/or the additive component of the precursor solution.

2. The method of Claim 1, wherein the dopant component comprises sufficient dopant metal to replace up to 50 atomic percent of one or more of the rare earth element and alkaline earth metal of the rare earth/alkaline earth metal/transition metal oxide.

3. The method of Claim 1 or 2, wherein the dopant component comprises sufficient dopant metal to (i) replace about 10 atomic % to about 30 atomic % of one or more of the rare earth element and the alkaline earth metal of the rare earth element/alkaline earth metal/transition metal oxide, or (ii) replace about 1 atomic % to about 10 atomic % of one or more of the rare earth element and the alkaline earth metal of the rare earth element/alkaline earth metal/transition metal oxide, or (iii) replace less than about 1 atomic % of one or more of the rare earth element and the alkaline earth metal of the rare earth element/alkaline earth metal/transition metal oxide.

4. The method of Claim 1, wherein treating the precursor film comprises heating the film at a temperature in the range of about 190°C to about 650°C to decompose the precursor and dopant and/or additive components of the precursor solution.

5. The method of Claim 1, wherein treating the precursor film comprises heating the film at a temperature in the range of about 190°C to about 400°C to decompose the precursor and dopant components of the precursor solution.

6. The method of Claim 1, further comprising:
heating the intermediate film to form an oxide superconductor, wherein the oxide superconductor comprises the dopant metal, and said oxide superconductor contains one or more defects that serve as pinning centers.

7. The method of Claim 6, wherein the oxide superconductor comprises sufficient dopant metal to replace up to 50 atomic percent of one or more of the rare ' earth element and the alkaline earth metal of the oxide superconductor.

8. The method of Claim 6, wherein heating the intermediate film comprises heating at a temperature in the range of about 700°C to about 825°C in a flowing gas environment having a total pressure of about 0.013 kPa (0.1 Torr) to about 101.33 kPa (760 Torr) and containing about 0.012 kPa (0.09 Torr) to about 6.67 kPa (50 Torr) oxygen and about 0.0013 kPa (0.01 Torr) to about 19.99 kPa (150 Torr) water vapour and an inert gas with a pressure of about 0 kPa (0 Torr) to about 99.99 kPa (750 Torr).

9. The method of Claim 6, wherein heating the intermediate film comprises heating at a temperature in the range of about 700°C to about 825°C in a flowing gas environment having a total pressure of about 0.019 kPa (0.15 Torr) to about 0.67 kPa (5 Torr) and containing about 0.013 kPa (0.1 Torr) to about 0.13 kPa (1 Torr) oxygen and about 0.006 kPa (0.05 Torr) to about 0.53 kPa (4 Torr) water vapor.

10. The method of Claim 8 or 9, wherein the film is heated to the heating temperature at a temperature ramp of about greater than 25°C per minute, or about greater than 100°C per minute, or about greater than 200°C per minute.

11. The method of Claim 6, wherein:
the oxide superconductor is disposed on a surface of a substrate, the substrate being biaxially oriented;
the oxide superconductor is biaxially oriented;
the oxide superconductor has a c-axis orientation that is substantially constant across its width, the c-axis orientation of the oxide superconductor being substantially perpendicular to the surface of the substrate.

12. The method of Claim 1, further comprising:
heating the intermediate film to form a rare earth element/alkaline earth metal/transition metal oxide superconductor, the oxide superconductor comprising the dopant metal, wherein the oxide superconductor comprises one or more second phase nanoparticles that serve as pinning centers.

13. The method of Claim 1, wherein the additive component comprises up to 0.5 - 20 atomic percent of the metals making up the precursor solution.

14. The method of Claim 1, wherein the additive component is in an amount sufficient to form a film having nanoparticles in a density of about 20 to about 10,000 particles/µm³, or about 100 to about 10,000 particles/µm³, or about 1,000 to about 10,000 particles/µm³.

15. The method of Claim 1, wherein the additive component is in an amount sufficient to form a film having nanoparticles in a density of greater than about 1,000 particles/µm³.

16. The method of Claim 1, further comprising:
heating the intermediate film to form a rare earth element/alkaline earth metal/transition metal oxide superconductor and one or more second phase nanoparticles, the or each secondary phase nanoparticle located within a grain of the oxide superconductor and serving as particulate pinning center.

17. The method of Claim 1, wherein the additive component comprises a dispersion of nanoparticles comprising one or more metal compounds capable of forming a second phase nanoparticle, either alone or in combination with one or more precursor salts of the rare earth element, alkaline earth metal or transition metal.

18. The method of Claim 17, wherein the nanoparticle dispersion is reactive with one or more elements of the precursor components of the precursor solution.

19. The method of Claim 17, wherein the nanoparticle is selected from the group consisting of zirconium oxide, aluminium oxide, Y₂BaCuO₅, Y₂Cu₂O₅, magnesium oxide, BaZrO₃, silver and ceria.

20. The method of Claim 1, wherein the additive component comprises one or more metal salts capable of forming a second phase nanoparticle, either alone or in combination with one or more precursor salts of the rare earth element, alkaline earth metal or transition metal.

21. The method of Claim 20, wherein the one or more metal salts of the additive component is reactive with one or more elements of the precursor components of the precursor solution.

22. The method of Claim 1, wherein the additive component comprises a stoichiometric excess of the rare earth element of the precursor solution, or a stoichiometric excess of the alkaline earth metal of the precursor solution.

23. The method of Claim 1, wherein the precursor solution comprises at least two rare earth elements, or at least two alkaline earth metals, or at least two transition metals.

24. The method of Claim 1, wherein the additive component comprises a salt of a metal selected from the group consisting of cerium, zirconium, silver, aluminium, and magnesium.

25. The method of Claim 1 comprising:
converting the precursor film to an oxide superconductor film,
wherein the oxide superconductor film is formed at a growth rate of 02-20 nm/s and
wherein the oxide superconductor film contains one or more second phase nanoparticles located within a grain of the oxide superconductor that serve as a pinning center.

26. The method of Claim 25, wherein the precursor film is converted to an oxide superconducting film at a growth rate of 05-20 nm/s or a growth rate of 1-20 nm/s.

27. The method of Claim 25, wherein the precursor film is converted to an oxide superconducting film at a growth rate of greater than 2 nm/s

28. The method of Claim 25, wherein the step of converting the precursor film to the oxide superconductor comprises at least two steps and comprises heating an intermediate film at a temperature in the range of about 700°C to about 825°C in a flowing gas environment having a total pressure of about 0.013 kPa (0.1 Torr) to about 101.33 kPa (760 Torr) and containing about 0.012 kPa (0.09 Torr) to about 6.67 kPa (50 Torr) oxygen and about 0.0013 kPa (0.01 Torr) to about 19.99 kPa (150 Torr) water vapour and an inert gas with a pressure of about 0 kPa (0 Torr) to about 99.99 kPa (750 Torr).

29. The method of Claim 25, wherein the step of converting the precursor film to the oxide superconductor comprises at least two steps and comprises heating an intermediate film at a temperature in the range of about 700°C to about 825°C in a flowing gas environment having a total pressure of about 0.019 kPa (0.15 Torr) to about 0.67 kPa (5 Torr) and containing about 0.013 kPa (0.1 Torr) to about 0.13 kPa (1 Torr) oxygen and about 0.006 kPa (0.05 Torr) to about 0.53 kPa (4 Torr) water vapour.

30. An article comprising:
a thin film on a substrate, wherein the thin film comprises a rare earth element/alkaline earth metal/transition metal oxide superconductor and a secondary particulate phase comprising a metal-containing compound located within the grain of the oxide superconductor, wherein the secondary particulate phase has a maximum dimension of 1-100 nm and serves as a pinning center, with the proviso that the metal-containing compound is not Y₂O₃ or Y₂BaCuO₅.

31. The article of Claim 30, wherein the secondary particulate phase is selected from the group consisting of zirconium oxide, aluminium oxide, silver, alkaline earth zirconates, and BaZrO₃ magnesium oxide.

32. The article of Claim 30, wherein the oxide superconductor comprises rare earth-barium-copper oxide.

33. The article of Claim 30, wherein said substrate is a dielectric oxide of a material selected from the group consisting of cerium oxide, lanthanum aluminium oxide, lanthanum manganese oxide, strontium titanium oxide, magnesium oxide, neodymium gadolinium oxide, and a cerium oxide/yttria-stabilized zirconia.

34. The article of Claim 30, wherein the second phase particulate or nanoparticle has at least one dimension of less than about 50 nm, or less than about 20 nm.

## Patentansprüche

1. Verfahren zum Herstellen eines Dünnfilms, umfassend:
Anordnen einer Vorläuferlösung auf einem Substrat, um einen Vorläuferfilm zu bilden, wobei die Vorläuferlösung umfasst:
Vorläuferkomponenten zu einem Seltenerdelement/Erdalkalimetall/Übergangsmetalloxid, umfassend ein Salz eines Seltenerdelementes, ein Salz eines Erdalkalimetalls und ein Salz eines Übergangsmetalls in einem oder mehreren Lösemitteln, wobei mindestens eines der Salze ein fluoridhaltiges Salz ist, und
eine Dotierkomponente und/oder eine Additivkomponente,
wobei das Dotiermittel eine Metallverbindung umfasst, die ein Dotiermetall aufweist, das fähig ist, eines oder mehrere von dem Seltenerdelement und dem Erdalkalimetall des Seltenerd/Erdalkalimetall/Übergangsmetalloxids zu ersetzen, und wobei die Additivkomponente eine oder mehrere Metallverbindungen umfasst, die fähig sind, entweder allein oder in Kombination mit einer oder mehreren der Vorläuferkomponenten der Vorläuferlösung ein Zweitphasen-Nanopartikel zu bilden; und
Behandeln des Vorläuferfilms, um einen intermediären Metalloxyfluorid-Film zu bilden, der das Seltenerdelement, das Erdalkalimetall, das Übergangsmetall und das Dotiermetall und/oder die Additivkomponente der Vorläuferlösung beinhaltet.

2. Verfahren nach Anspruch 1, wobei die Dotierkomponente ausreichend Dotiermetall umfasst, um bis zu 50 Atomprozent von einem oder mehreren von dem Seltenerdelement und dem Erdalkalimetall des Seltenerd/Erdalkalimetall/Übergangsmetalloxids zu ersetzen.

3. Verfahren nach Anspruch 1 oder 2, wobei die Dotierkomponente ausreichend Dotiermetall umfasst, um (i) etwa 10 Atom-% bis etwa 30 Atom-% von einem oder mehreren von dem Seltenerdelement und dem Erdalkalimetall des Seltenerdelement/Erdalkalimetall/Übergangsmetalloxids zu ersetzen oder (ii) etwa 1 Atom-% bis etwa 10 Atom-% von einem oder mehreren von dem Seltenerdelement und dem Erdalkalimetall des Seltenerdelement/Erdalkalimetall/Übergangsmetalloxids zu ersetzen oder (iii) weniger als etwa 1 Atom-% von einem oder mehreren von dem Seltenerdelement und dem Erdalkalimetall des Seltenerdelement/Erdalkalimetall/Übergangsmetalloxids zu ersetzen.

4. Verfahren nach Anspruch 1, wobei das Behandeln des Vorläuferfilms das Erhitzen des Films auf eine Temperatur in dem Bereich von etwa 190 °C bis etwa 650 °C umfasst, um die Vorläufer- und Dotier- und/oder Additivkomponenten der Vorläuferlösung zu zersetzen.

5. Verfahren nach Anspruch 1, wobei das Behandeln des Vorläuferfilms das Erhitzen des Films auf eine Temperatur in dem Bereich von etwa 190 °C bis etwa 400 °C umfasst, um die Vorläufer- und Dotierkomponenten der Vorläuferlösung zu zersetzen.

6. Verfahren nach Anspruch 1, ferner umfassend:
Erhitzen des intermediären Films, um einen Oxidsupraleiter zu bilden, wobei der Oxidsupraleiter das Dotiermetall umfasst und der Oxidsupraleiter einen oder mehrere Defekte aufweist, die als Verankerungszentren dienen.

7. Verfahren nach Anspruch 6, wobei der Oxidsupraleiter ausreichend Dotiermetall umfasst, um bis zu 50 Atomprozent von einem oder mehreren von dem Seltenerdelement und dem Erdalkalimetall des Oxidsupraleiters zu ersetzen.

8. Verfahren nach Anspruch 6, wobei das Erhitzen des intermediären Films das Erhitzen auf eine Temperatur in dem Bereich von etwa 700 °C bis etwa 825 °C in einer Fließgasumgebung umfasst, die einen Gesamtdruck von etwa 0,013 kPa (0,1 Torr) bis etwa 101,33 kPa (760 Torr) aufweist und etwa 0,012 kPa (0,09 Torr) bis etwa 6,67 kPa (50 Torr) Sauerstoff und etwa 0,0013 kPa (0,01 Torr) bis etwa 19,99 kPa (150 Torr) Wasserdampf und ein Inertgas mit einem Druck von etwa 0 kPa (0 Torr) bis etwa 99,99 kPa (750 Torr) enthält.

9. Verfahren nach Anspruch 6, wobei das Erhitzen des intermediären Films das Erhitzen auf eine Temperatur in dem Bereich von etwa 700 °C bis etwa 825 °C in einer Fließgasumgebung umfasst, die einen Gesamtdruck von etwa 0,019 kPa (0,15 Torr) bis etwa 0,67 kPa (5 Torr) aufweist und etwa 0,013 kPa (0,1 Torr) bis etwa 0,13 kPa (1 Torr) Sauerstoff und etwa 0,006 kPa (0,05 Torr) bis etwa 0,53 kPa (4 Torr) Wasserdampf enthält.

10. Verfahren nach Anspruch 8 oder 9, wobei der Film mit einem Temperaturanstieg von etwa größer als 25 °C pro Minute oder etwa größer als 100 °C pro Minute oder etwa größer als 200 °C pro Minute auf die Heiztemperatur erhitzt wird.

11. Verfahren nach Anspruch 6, wobei:
der Oxidsupraleiter auf einer Oberfläche eines Substrats angeordnet wird, wobei das Substrat biaxial ausgerichtet wird;
der Oxidsupraleiter biaxial ausgerichtet wird;
der Oxidsupraleiter eine C-Achsen-Ausrichtung aufweist, die über seine Breite im Wesentlichen konstant ist, wobei die C-Achsen-Ausrichtung des Oxidsupraleiters im Wesentlichen rechtwinklig zu der Oberfläche des Substrats ist.

12. Verfahren nach Anspruch 1, ferner umfassend:
Erhitzen des intermediären Films, um einen Seltenerdelement/Erdalkalimetall/Übergangsmetalloxid-Supraleiter zu bilden, wobei der Oxidsupraleiter das Dotiermetall umfasst, wobei der Oxidsupraleiter ein oder mehrere Zweitphasen-Nanopartikel umfasst, die als Verankerungszentren dienen.

13. Verfahren nach Anspruch 1, wobei die Additivkomponente bis zu 0,5 bis 20 Atomprozent der Metalle umfasst, die die Vorläuferlösung bilden.

14. Verfahren nach Anspruch 1, wobei die Additivkomponente in einer Menge ist, die ausreicht, um einen Film zu bilden, der Nanopartikel in einer Dichte von etwa 20 bis etwa 10.000 Partikel/µm³ oder etwa 100 bis etwa 10.000 Partikel/µm³ oder etwa 1.000 bis etwa 10.000 Partikel/µm³ aufweist.

15. Verfahren nach Anspruch 1, wobei die Additivkomponente in einer Menge ist, die ausreicht, um einen Film zu bilden, der Nanopartikel in einer Dichte von größer als etwa 1.000 Partikel/µm³ aufweist.

16. Verfahren nach Anspruch 1, ferner umfassend:
Erhitzen des intermediären Films, um einen Seltenerdelement/Erdalkalimetall/Übergangsmetalloxid-Supraleiter und ein oder mehrere Zweitphasen-Nanopartikel zu bilden, wobei das oder jedes Sekundärphasenpartikel sich innerhalb eines Korns des Oxidsupraleiters befindet und als ein Partikelverankerungszentrum dient.

17. Verfahren nach Anspruch 1, wobei die Additivkomponente eine Dispersion von Nanopartikeln umfasst, die eine oder mehrere Metallverbindungen umfassen, die fähig sind, entweder allein oder in Kombination mit einem oder mehreren Vorläufersalzen des Seltenerdelementes, Erdalkalimetalls oder Übergangsmetalls ein Zweitphasen-Nanopartikel zu bilden.

18. Verfahren nach Anspruch 17, wobei die Nanopartikeldispersion mit einem oder mehreren Elementen der Vorläuferkomponenten der Vorläuferlösung reaktiv ist.

19. Verfahren nach Anspruch 17, wobei das Nanopartikel aus der Gruppe ausgewählt wird, die aus Zirkoniumoxid, Aluminiumoxid, Y₂BaCuO₅, Y₂Cu₂O₅, Magnesiumoxid, BaZrO₃ Silber und Cerdioxid besteht.

20. Verfahren nach Anspruch 1, wobei die Additivkomponente ein oder mehrere Metallsalze umfasst, die fähig sind, entweder allein oder in Kombination mit einem oder mehreren Vorläufersalzen des Seltenerdelementes, Erdalkalimetalls oder Übergangsmetalls ein Zweitphasen-Nanopartikel zu bilden.

21. Verfahren nach Anspruch 20, wobei das eine oder die mehreren Metallsalze der Additivkomponente mit einem oder mehreren Elementen der Vorläuferkomponenten der Vorläuferlösung reaktiv ist.

22. Verfahren nach Anspruch 1, wobei die Additivkomponente einen stöchiometrischen Überschuss des Seltenerdelementes der Vorläuferlösung oder einen stöchiometrischen Überschuss des Erdalkalimetalls der Vorläuferlösung umfasst.

23. Verfahren nach Anspruch 1, wobei die Vorläuferlösung mindestens zwei Seltenerdelemente oder mindestens zwei Erdalkalimetalle oder mindestens zwei Übergangsmetalle umfasst.

24. Verfahren nach Anspruch 1, wobei die Additivkomponente ein Salz eines Metalls umfasst, das aus der Gruppe ausgewählt wird, die aus Cer, Zirkonium, Silber, Aluminium und Magnesium besteht.

25. Verfahren nach Anspruch 1, umfassend:
Umwandeln des Vorläuferfilms zu einem Oxidsupraleiterfilm,
wobei der Oxidsupraleiterfilm mit einer Wachstumsgeschwindigkeit von 0,2 bis 20 nm/s gebildet wird
und
wobei der Oxidsupraleiterfilm eine oder mehrere Zweitphasen-Nanopartikel enthält, die sich innerhalb eines Korns des Oxidsupraleiters befinden und als ein Verankerungszentrum dienen.

26. Verfahren nach Anspruch 25, wobei der Vorläuferfilm mit einer Wachstumsgeschwindigkeit von 0,5 bis 20 nm/s oder einer Wachstumsgeschwindigkeit von 1 bis 20 nm/s zu einem supraleitenden Oxidfilm umgewandelt wird.

27. Verfahren nach Anspruch 25, wobei der Vorläuferfilm mit einer Wachstumsgeschwindigkeit von größer als 2 nm/s zu einem supraleitenden Oxidfilm umgewandelt wird.

28. Verfahren nach Anspruch 25, wobei der Schritt des Umwandelns des Vorläuferfilms zu dem Oxidsupraleiter mindestens zwei Schritte umfasst und das Erhitzen eines intermediären Films auf eine Temperatur in dem Bereich von etwa 700 °C bis etwa 825 °C in einer Fließgasumgebung umfasst, die einen Gesamtdruck von etwa 0,013 kPa (0,1 Torr) bis etwa 101,33 kPa (760 Torr) aufweist und etwa 0,012 kPa (0,09 Torr) bis etwa 6,67 kPa (50 Torr) Sauerstoff und etwa 0,0013 kPa (0,01 Torr) bis etwa 19,99 kPa (150 Torr) Wasserdampf und ein Inertgas mit einem Druck von etwa 0 kPa (0 Torr) bis etwa 99,99 kPa (750 Torr) enthält.

29. Verfahren nach Anspruch 25, wobei der Schritt des Umwandelns des Vorläuferfilms zu dem Oxidsupraleiter mindestens zwei Schritte umfasst und das Erhitzen eines intermediären Films auf eine Temperatur in dem Bereich von etwa 700 °C bis etwa 825 °C in einer Fließgasumgebung umfasst, die einen Gesamtdruck von etwa 0,019 kPa (0,15 Torr) bis etwa 0,67 kPa (5 Torr) aufweist und etwa 0,013 kPa (0,1 Torr) bis etwa 0,13 kPa (1 Torr) Sauerstoff und etwa 0,006 kPa (0,05 Torr) bis etwa 0,53 kPa (4 Torr) Wasserdampf enthält.

30. Gegenstand, umfassend:
einen Dünnfilm auf einem Substrat, wobei der Dünnfilm einen Seltenerdelement/Erdalkalimetall/Übergangsmetalloxid-Supraleiter und eine Sekundärpartikelphase umfasst, die eine metallhaltige Verbindung umfasst, die sich innerhalb des Korns des Oxidsupraleiters befindet, wobei die Sekundärpartikelphase eine maximale Abmessung von 1 bis 100 nm aufweist und als ein Verankerungszentrum dient, mit der Maßgabe, dass die metallhaltige Verbindung nicht Y₂O₃ oder Y₂BaCuO₅ ist.

31. Gegenstand nach Anspruch 30, wobei die Sekundärpartikelphase aus der Gruppe ausgewählt ist, die aus Zirkoniumoxid, Aluminiumoxid, Silber, Erdalkalizirkonaten und BaZrO₃ Magnesiumoxid besteht.

32. Gegenstand nach Anspruch 30, wobei der Oxidsupraleiter Seltenerd-Barium-Kupferoxid umfasst.

33. Gegenstand nach Anspruch 30, wobei das Substrat ein dielektrisches Oxid aus einem Material ist, das aus der Gruppe ausgewählt ist, die aus Ceroxid, Lanthanaluminiumoxid, Lanthanmanganoxid, Strontiumtitanoxid, Magnesiumoxid, Neodymgadoliniumoxid und einem mit Ceroxid/Yttriumoxid stabilisierten Zirkoniumdioxid besteht.

34. Gegenstand nach Anspruch 30, wobei das Zweitphasenpartikel oder - Nanopartikel mindestens eine Abmessung von weniger als etwa 50 nm oder weniger als etwa 20 nm aufweist.

## Revendications

1. Méthode de production d'un film mince, comprenant :
le dépôt d'une solution de précurseurs sur un substrat pour former un film précurseur, la solution de précurseurs contenant :
des composants précurseurs d'un oxyde de terre rare/métal alcalino-terreux/métal de transition comprenant un sel de terre rare, un sel de métal alcalino-terreux et un sel de métal de transition dans un ou plusieurs solvants, au moins un des sels étant un sel contenant du fluor, et
un composant dopant et/ou un composant additif,
dans lequel le dopant comprend un composé métallique contenant un métal dopant capable de remplacer un ou plusieurs de la terre rare et du métal alcalino-terreux de l'oxyde de terre rare/métal alcalino-terreux/métal de transition, et dans lequel le composant additif comprend un ou plusieurs composés métalliques capables de former une nanoparticule de seconde phase, soit seul, soit en combinaison avec un ou plusieurs des composants précurseurs de la solution de précurseurs ; et
le traitement du film précurseur pour former un film intermédiaire d'oxyfluorure métallique contenant le terre rare, le métal alcalino-terreux, le métal de transition et le métal dopant et/ou le composant additif de la solution de précurseurs.

2. Méthode selon la revendication 1, dans laquelle le composant dopant comprend suffisamment de métal dopant pour remplacer jusqu'à 50 pour cent atomique de un ou plusieurs de la terre rare et du métal alcalino-terreux de l'oxyde de terre rare/métal alcalino-terreux/métal de transition.

3. Méthode selon la revendication 1 ou 2, dans laquelle le composant dopant comprend suffisamment de métal dopant pour (i) remplacer environ 10 % atomique à environ 30 % atomique de un ou plusieurs de la terre rare et du métal alcalino-terreux de l'oxyde de terre rare/métal alcalino-terreux/métal de transition, ou (ii) remplacer environ 1 % atomique à environ 10 % atomique de un ou plusieurs de la terre rare et du métal alcalino-terreux de l'oxyde de terre rare/métal alcalino-terreux/métal de transition, ou (iii) remplacer moins d'environ 1 % atomique de un ou plusieurs de la terre rare et du métal alcalino-terreux de l'oxyde de terre rare/métal alcalino-terreux/métal de transition.

4. Méthode selon la revendication 1, dans laquelle le traitement du film précurseur comprend le chauffage du film à une température située dans la plage allant d'environ 190°C à environ 650°C pour décomposer le précurseur et les composants dopant et/ou additif de la solution de précurseurs.

5. Méthode selon la revendication 1, dans laquelle le traitement du film précurseur comprend le chauffage du film à une température située dans la plage allant d'environ 190°C à environ 400°C pour décomposer le précurseur et les composants dopants de la solution de précurseurs.

6. Méthode selon la revendication 1, comprenant en outré :
le chauffage du film intermédiaire pour former un oxyde supraconducteur, dans lequel l'oxyde supraconducteur comprend le métal dopant et ledit oxyde supraconducteur contient un ou plusieurs défauts servant de centres d'ancrage.

7. Méthode selon la revendication 6, dans laquelle l'oxyde supraconducteur comprend suffisamment de métal dopant pour remplacer jusqu'à 50 pour cent atomique de un ou plusieurs de la terre rare et du métal alcalino-terreux de l'oxyde supraconducteur.

8. Méthode selon la revendication 6, dans laquelle le chauffage du film intermédiaire comprend un chauffage à une température située dans la plage allant d'environ 700°C à environ 825°C dans un environnement à écoulement gazeux présentant une pression totale d'environ 0,013 kPa (0,1 Torr) à environ 101,33 kPa (760 Torr) et contenant environ 0,012 kPa (0,09 Torr) à environ 6,67 kPa (50 Torr) d'oxygène et environ 0,0013 kPa (0,01 Torr) à environ 19,99 kPa (150 Torr) de vapeur d'eau et un gaz inerte ayant une pression d'environ 0 kPa (0 Torr) à environ 99,99 kPa (750 Torr).

9. Méthode selon la revendication 6, dans laquelle le chauffage du film intermédiaire comprend un chauffage à une température située dans la plage allant d'environ 700°C à environ 825°C dans un environnement à écoulement gazeux présentant une pression totale d'environ 0,019 kPa (0,15 Torr) à environ 0,67 kPa (5 Torr) et contenant environ 0,013 kPa (0,1 Torr) à environ 0,13 kPa (1 Torr) d'oxygène et environ 0,006 kPa (0,05 Torr) à environ 0,53 kPa (4 Torr) de vapeur d'eau.

10. Méthode selon la revendication 8 ou 9, dans laquelle le film est chauffé à la température de chauffage avec une rampe de température de plus d'environ 25°C par minute, ou de plus d'environ 100°C par minute, ou de plus d'environ 200°C par minute.

11. Méthode selon la revendication 6, dans laquelle :
l'oxyde supraconducteur est disposé sur une surface d'un substrat, le substrat étant orienté biaxialement ;
l'oxyde supraconducteur est orienté biaxialement ;
l'oxyde supraconducteur présente une orientation selon un axe c qui est sensiblement constante à travers sa largeur, l'orientation selon l'axe c de l'oxyde supraconducteur étant sensiblement perpendiculaire à la surface du substrat.

12. Méthode selon la revendication 1, comprenant en outré :
le chauffage du film intermédiaire pour former un oxyde de terre rare/métal alcalino-terreux/métal de transition supraconducteur, l'oxyde supraconducteur comprenant le métal dopant, dans lequel l'oxyde supraconducteur comprend une ou plusieurs nanoparticules de seconde phase jouant le rôle de centres d'ancrage.

13. Méthode selon la revendication 1, dans laquelle le composant additif comprend jusqu'à 0,5 à 20 pour cent atomique des métaux composant la solution de précurseurs.

14. Méthode selon la revendication 1, dans laquelle le composant additif est présent en une quantité suffisante pour former un film contenant des nanoparticules à une densité d'environ 20 à environ 10 000 particules/µm³, ou d'environ 100 à environ 10 000 particules/µm³, ou d'environ 1 000 à environ 10 000 particules/µm³.

15. Méthode selon la revendication 1, dans laquelle le composant additif est présent en une quantité suffisante pour former un film contenant des nanoparticules à une densité supérieure à environ 1 000 particules/µm³.

16. Méthode selon la revendication 1, comprenant en outré :
le chauffage du film intermédiaire pour former un oxyde de terre rare/métal alcalino-terreux/métal de transition supraconducteur et une ou plusieurs nanoparticules de seconde phase, la ou chaque nanoparticule de phase secondaire étant située au sein d'un grain de l'oxyde supraconducteur et jouant le rôle de centre particulaire d'ancrage.

17. Méthode selon la revendication 1, dans laquelle le composant additif comprend une dispersion de nanoparticules comprenant un ou plusieurs composés métalliques capables de former une nanoparticule de seconde phase, soit seul, soit en combinaison avec un ou plusieurs sels précurseurs de terre rare, du métal alcalino-terreux ou du métal de transition.

18. Méthode selon la revendication 17, dans laquelle la dispersion de nanoparticules est réactive avec un ou plusieurs éléments des composants précurseurs de la solution de précurseurs.

19. Méthode selon la revendication 17, dans laquelle la nanoparticule est choisie dans le groupe constitué de l'oxyde de zirconium, de l'oxyde d'aluminium, de Y₂BaCuO₅, de Y₂Cu₂O₅, de l'oxyde de magnésium, de BaZrO₃, de l'argent et de l'oxyde cérium.

20. Méthode selon la revendication 1, dans laquelle le composant additif comprend un ou plusieurs sels métalliques capables de former une nanoparticule de seconde phase, soit seul, soit en combinaison avec un ou plusieurs sels précurseurs de terre rare, du métal alcalino-terreux ou du métal de transition.

21. Méthode selon la revendication 20, dans laquelle le ou les sels métalliques du composant additif sont réactifs avec un ou plusieurs éléments des composants précurseurs de la solution de précurseurs.

22. Méthode selon la revendication 1, dans laquelle le composant additif comprend un excès stoechiométrique de la terre rare de la solution de précurseurs, ou un excès stoechiométrique du métal alcalino-terreux de la solution de précurseurs.

23. Méthode selon la revendication 1, dans laquelle la solution de précurseurs contient au moins deux terres rares, ou au moins deux métaux alcalino-terreux, ou au moins deux métaux de transition.

24. Méthode selon la revendication 1, dans laquelle le composant additif comprend un sel de métal choisi dans le groupe constitué du cérium, du zirconium, de l'argent, de l'aluminium et du magnésium.

25. Méthode selon la revendication 1, comprenant :
la conversion du film précurseur en film d'oxyde supraconducteur,
dans laquelle le film d'oxyde supraconducteur est formé à une vitesse de croissance de 0,2 nm/s à 20 nm/s, et
dans laquelle le film d'oxyde supraconducteur contient une ou plusieurs nanoparticules de seconde phase situées au sein d'un grain de l'oxyde supraconducteur et jouant le rôle de centre d'ancrage.

26. Méthode selon la revendication 25, dans laquelle le film précurseur est converti en film d'oxyde supraconducteur à une vitesse de croissance de 0,5 nm/s à 20 nm/s ou à une vitesse de croissance de 1 nm/s à 20 nm/s.

27. Méthode selon la revendication 25, dans laquelle le film précurseur est converti en film d'oxyde supraconducteur à une vitesse de croissance supérieure à 2 nm/s.

28. Méthode selon la revendication 25, dans laquelle l'étape de conversion du film précurseur en oxyde supraconducteur comprend au moins deux étapes et comprend le chauffage d'un film intermédiaire à une température située dans la plage allant d'environ 700°C à environ 825°C dans un environnement à écoulement gazeux présentant une pression totale d'environ 0,013 kPa (0,1 Torr) à environ 101,33 kPa (760 Torr) et contenant environ 0,012 kPa (0,09 Torr) à environ 6,67 kPa (50 Torr) d'oxygène et environ 0,0013 kPa (0,01 Torr) à environ 19,99 kPa (150 Torr) de vapeur d'eau et un gaz inerte ayant une pression d'environ 0 kPa (0 Torr) à environ 99,99 kPa (750 Torr).

29. Méthode selon la revendication 25, dans laquelle l'étape de conversion du film précurseur en oxyde supraconducteur comprend au moins deux étapes et comprend le chauffage d'un film intermédiaire à une température située dans la plage allant d'environ 700°C à environ 825°C dans un environnement à écoulement gazeux présentant une pression totale d'environ 0,019 kPa (0,15 Torr) à environ 0,67 kPa (5 Torr) et contenant environ 0,013 kPa (0,1 Torr) à environ 0,13 kPa (1 Torr) d'oxygène et environ 0,006 kPa (0,05 Torr) à environ 0,53 kPa (4 Torr) de vapeur d'eau.

30. Article comprenant :
un film mince sur un substrat, dans lequel le film mince comprend un oxyde de terre rare/métal alcalino-terreux/métal de transition supraconducteur et une phase particulaire secondaire comprenant un composé contenant un métal situé au sein du grain de l'oxyde supraconducteur, la phase particulaire secondaire ayant une dimension maximale de 1 nm à 100 nm et jouant le rôle de centre d'ancrage, à condition que le composé contenant un métal ne soit pas Y₂O₃ ou Y₂BaCuO₅.

31. Article selon la revendication 30, dans lequel la phase particulaire secondaire est choisie dans le groupe constitué de l'oxyde de zirconium, de l'oxyde d'aluminium, de l'argent, des zirconates de métaux alcalino-terreux, de BaZrO₃ et de l'oxyde de magnésium.

32. Article selon la revendication 30, dans lequel l'oxyde supraconducteur comprend un oxyde de terre rare-baryum-cuivre.

33. Article selon la revendication 30, dans lequel ledit substrat est un oxyde diélectrique d'une matière choisie dans le groupe constitué de l'oxyde de cérium, de l'oxyde de lanthane et d'aluminium, de l'oxyde de lanthane et de manganèse, de l'oxyde de strontium et de titane, de l'oxyde de magnésium, de l'oxyde de néodyme et de gadolinium et d' un oxyde de cérium/zircone stabilisée à l'oxyde d'yttrium.

34. Article selon la revendication 30, dans lequel la particule ou nanoparticule de seconde phase possède au moins une dimension inférieure à environ 50 nm, ou inférieure à environ 20 nm.
